# EUROPEAN PATENT SPECIFICATION

(11) **EP 3 451 365 B1**
(45) Date of publication and mention of the grant of the patent: **16.08.2023**
(21) Application number: 17789448.2
(22) Date of filing: 24.04.2017
(51) Int. Cl.: H01L 21/265, H01L 21/268, H01L 21/336, H01L 29/739, H01L 29/78

(54) **LASER ANNEALING METHOD**
LASERGLÜHVERFAHREN
PROCÉDÉ DE RECUIT LASER

(30) Priority: 27.04.2016 JP 2016089018; 27.09.2016 JP 2016187992
(43) Date of publication of application: 06.03.2019
(73) Proprietor: Sumitomo Heavy Industries, Ltd., Tokyo 141-6025 (JP)
(72) Inventor: WAKABAYASHI, Naoki, Yokosuka-shi, Kanagawa 237-8555 (JP)
(74) Representative: Louis Pöhlau Lohrentz
(86) International application number: PCT/JP2017/016132
(87) International publication number: WO 2017/188166

(56) References cited:
- WO-A1-2013/108911
- WO-A1-2016/080288
- JP-A- 2003 059 856
- JP-A- 2006 344 977
- JP-A- 2009 099 705
- JP-A- 2009 176 892
- US-A1- 2009 121 157
- US-A1- 2013 017 674
- US-A1- 2014 057 457

## Description

### Technical Field

The present invention relates to a laser annealing method, in which an element that is combined with a lattice defect within crystal and serves as a donor is implanted in a silicon wafer and annealing is performed so that the implanted element is activated.

### Background Art

It is known that an n-type carrier density rises when protons are implanted in a silicon wafer to generate a lattice defect and annealing is performed. In this case, protons serve as a donor. It is assumed that protons serve as a donor due to a complex defect caused by the protons and empty holes. When protons are implanted in a silicon wafer and serve as a donor, it is also referred to as activation of protons. For example, protons can be activated by performing annealing at 500°C for 30 minutes using an electric furnace (PTL 1).

A technology, in which protons implanted on an outer surface on a side opposite to an element surface of an insulated gate bipolar transistor (IGBT) are activated through laser annealing, is known (PTL 2). In the method disclosed in PTL 2, a silicon wafer is irradiated with laser light having a wavelength of 808 nm and laser light having a wavelength of approximately 500 nm at the same time. A semiconductor laser is used as a light source of the laser light having a wavelength of 808 nm, and a YAG2ω laser is used as a light source of the laser light having a wavelength of approximately 500 nm. The intrusion length of the laser light having a wavelength of 808 nm with respect to the silicon wafer is longer than the intrusion length of the laser light having a wavelength of 500 nm with respect to the silicon wafer. A relatively deep region is heated with laser light having a long intrusion length, and a relatively shallow region is heated with laser light having a short intrusion length.

In the method disclosed in PTL 2, it takes an extremely short time, that is, 1 µs from a rise to a fall of the temperature in laser annealing. Therefore, it is necessary for silicon to be in a melted state or a similar state to activate protons. In the method disclosed in PTL 2, a silicon wafer is melted to a depth of approximately 30 µm, for example, to activate protons. A deeper region in a silicon wafer can be melted by using rays of laser light having wavelengths of two different kinds of intrusion lengths.

It is known that when protons are implanted, a concentration in a proton passing region from the outer surface of a silicon wafer to a depth corresponding to a projection range Rp of the protons becomes extremely lower than an initial donor concentration of a dopant which has been originally doped in the silicon wafer (PTL 3). As a reason thereof, it is assumed that a defect of a strongly turbulent crystal state which may cause a decrease in carrier mobility or a leakage current is generated due to irradiation of protons . Such a defect is called a disorder.

It is possible to form a field stop layer having no disorder by performing irradiation of protons three times while changing acceleration energy and performing furnace annealing for activating the protons for each of the three times of irradiation (PTL 3).

### Citation List

### Patent Literature

[PTL 1] Japanese Unexamined Patent Application Publication No. 2009-099705
[PTL 2] Japanese Unexamined Patent Application Publication No. 2009-176892
[PTL 3] International Publication No. WO 2013/147275

Further patent document US 2013/017674 A discloses a method for activation of donors in silicon wafers using a non-melt laser annealing.

### Summary of Invention

### Technical Problem

As described above, an n-type carrier by protons is generated due to a complex defect. When an annealing temperature is excessively high, the complex defect serving as a donor is recovered and eliminated. Therefore, an upper limit value for a preferable range of the annealing temperature for activating protons is present. In a case of performing annealing using an electric furnace, the annealing temperature cannot be set higher than this upper limit value. Therefore, in annealing, it is difficult to eliminate an end-of-range (EOR) defect generated in an end-of-range region through ion-implantation. Here, the end-of-range region denotes a region from a position (peak depth) at which the concentration of an implanted dopant indicates a peak to a deepest position (tail depth) the dopant reaches. In a region in which an EOR defect remains, there are cases where the density of the n-type carrier is lower than an initial donor concentration of an n-type silicon wafer.

In a method of activating protons by melting an outer layer portion of a silicon wafer (method disclosed in PTL 2), the energy density on an outer surface of the silicon wafer has to be increased in order to melt silicon. As an example, a case where a silicon wafer is melted to a depth of 30 µm will be studied. Since silicon has enthalpy of 1,780 J/g, a region of an area of 1 cm² requires latent heat of 12.4 J/cm² to melt the silicon to the depth of 30 µm. Laser energy corresponding to the energy density of 12.4 J/cm² is consumed for only melting the silicon. When laser annealing is performed, energy for heating the silicon wafer to a melting point is also required in addition to energy corresponding to the latent heat. Therefore, an energy density higher than 12.4 J/cm² is required to melt a silicon wafer to the depth of 30 µm.

In a case of performing continuous oscillation of a semiconductor laser having a wavelength of 808 nm, the output of a laser oscillator has to be increased or the moving speed of a beam spot on the outer surface of a silicon wafer has to be reduced in order to increase the energy density. Energy per pulse has to be increased or the beam spot size has to be reduced in order to increase the energy density of a YAG2ω laser for pulse oscillation having a wavelength of approximately 500 nm. Both cases result in high cost of the laser oscillator or a decrease in throughput.

In addition, in a method disclosed in PTL 2, a relatively deep region is heated with laser light having a long intrusion length. Incidentally, the intrusion length of light with respect to the silicon wafer depends on the temperature of a silicon wafer. When the temperature of a silicon wafer rises, an energy bandgap is reduced. As a result, the intrusion length of light becomes short. When the temperature of a silicon wafer becomes high due to incident laser light, the intrusion length becomes short. Therefore, the intrusion length while laser light is continuously incident becomes shorter than the intrusion length of an initial incident laser.

In a step of manufacturing an IGBT, an IGBT element structure is already formed in a silicon wafer at the time protons are activated through furnace annealing. This element structure includes aluminum, for example. Therefore, it is not possible to perform heating to a temperature or higher at which aluminum and silicon form silicide during annealing for activating protons. In a method disclosed in PTL 3, furnace annealing is performed three times at 420°C, 400°C, and 380°C. It is difficult to efficiently eliminate a disorder through furnace annealing at such temperatures.

An object of the present invention is to provide a laser annealing method by which an EOR defect can be reduced and a laser oscillator having a high output to the extent of melting a silicon wafer is no longer necessary. Another object of the present invention is to provide a laser annealing method by which a disorder can be reduced after implantation of protons or the like.

### Solution to Problem

The invention is directed to a laser annealing method as defined in claim 1. The preferred embodiments are defined in dependent claims 2-5.

### Advantageous Effects of Invention

In electric furnace annealing, it is difficult to eliminate an EOR defect. However, it is possible to drastically reduce an EOR defect through annealing using a pulse laser compared to a case of using electric furnace annealing. Moreover, a condition that the laser irradiation surface of the silicon wafer does not melt is applied. Therefore, it is possible to use a laser oscillator having a small output compared to a case where the outer surface melts.

Element characteristics can be improved by eliminating a disorder.

### Brief Description of Drawings

FIG. 1A is a cross-sectional view of an IGBT manufactured by applying a laser annealing method according to an embodiment, and FIG. 1B is a cross-sectional view of a silicon wafer in a phase of performing laser annealing.
FIG. 2A is a graph illustrating a relationship between a temperature of silicon and a bandgap, and FIG. 2B is a graph illustrating a relationship between the temperature of silicon and a light intrusion length.
FIG. 3 is a graph illustrating a simulation result of a relationship between a depth and a highest temperature in a case where a laser beam is caused to be incident on condition that the highest temperature on an outer surface becomes a melting point (1,414°C) of silicon.
FIG. 4A is a cross-sectional view of a silicon wafer that is an annealing target, FIG. 4B is a cross-sectional view of a silicon wafer after laser annealing, and FIG. 4C is a graph illustrating a distribution of a carrier density related to a thickness direction of a silicon wafer after laser annealing.
FIG. 5A is a cross-sectional view of a silicon wafer after protons are implanted by a laser annealing method according to another embodiment, FIG. 5B is a cross-sectional view of a silicon wafer after furnace annealing, and FIG. 5C is a cross-sectional view of a silicon wafer after laser annealing.
FIG. 6A is a cross-sectional view of a silicon wafer used in an evaluation experiment, and FIG. 6B is a cross-sectional view of a silicon wafer after laser annealing.
FIG. 7 is a graph illustrating a measurement result of a distribution of the carrier density of a silicon wafer after laser annealing related to a depth direction.
FIG. 8 is a graph illustrating a measurement result of a distribution of the carrier density related to the depth direction of samples subjected to laser annealing under the condition described above.
FIG. 9 is a graph illustrating a simulation result of a distribution of the highest temperature related to the depth direction in a case of performing laser annealing on condition that the highest temperature on the outer surface of a silicon wafer substantially reaches the melting point of silicon.
FIG. 10 is a table showing a simulation result of a relationship among a thickness of a silicon wafer, a pulse width, and the highest temperature on a non-irradiation surface.
FIGs. 11A to 11E are cross-sectional views of a silicon wafer for describing a method of manufacturing an IGBT.
FIG. 12 is a graph illustrating a measurement result of a distribution of the carrier density in an outer layer portion on a laser irradiation surface 10B of a silicon wafer 10.
FIGs. 13A to 13E are cross-sectional views of a silicon wafer for describing another method of manufacturing an IGBT.
FIG. 14 is a schematic view of a laser annealing device according to the embodiment.
FIG. 15 is a graph illustrating a relationship (first relationship) between the thickness of a silicon wafer and an upper limit value for the pulse width satisfying a condition that the highest temperature on the non-irradiation surface becomes 400°C or lower.
FIGs. 16A and 16B are graphs illustrating a relationship (second relationship) between the pulse width of an incident pulsed laser beam and a range of the depth in which protons implanted in a silicon wafer are activated.
FIG. 17 is a block diagram of a function of a control device.
FIG. 18 is a graph illustrating a measurement result of the carrier density when protons are activated in another evaluation experiment.
FIG. 19 is a graph illustrating a measurement result of the carrier density when protons are activated in still another evaluation experiment.
FIG. 20 is a graph illustrating a measurement result of the carrier density when protons are activated in further another evaluation experiment.
FIG. 21 is a graph illustrating a measurement result of the carrier density when protons are activated in yet another evaluation experiment.

### Description of Embodiment

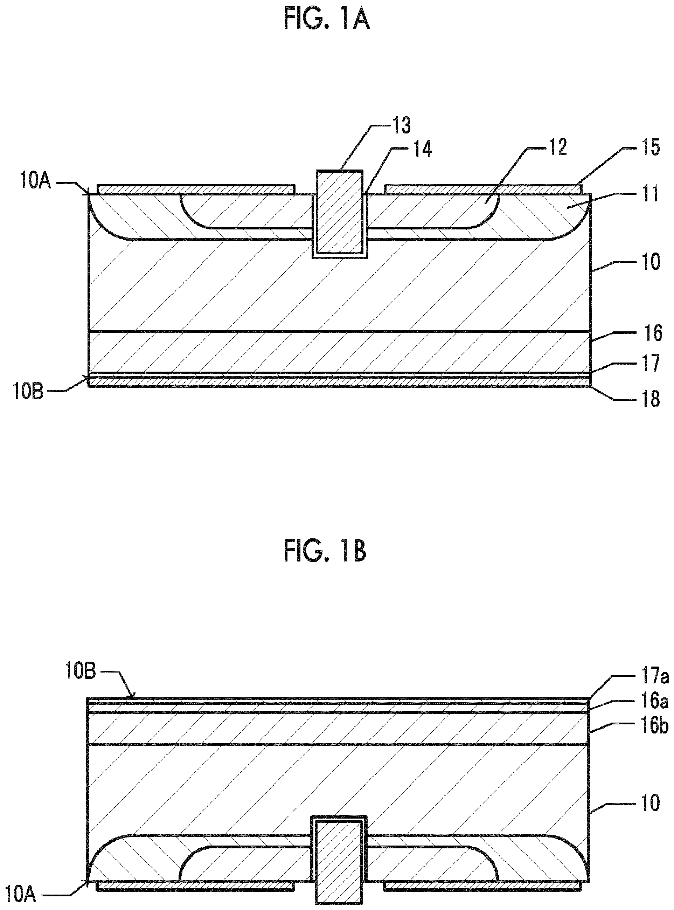

With reference to FIGs. 1A and 1B, a structure of an insulated gate bipolar transistor (IGBT) will be simply described as an example of a semiconductor element produced by applying a laser annealing method according to an embodiment.

FIG. 1A is a cross-sectional view of an IGBT manufactured by applying the laser annealing method according to the embodiment. An element structure including an emitter, a gate, and the like is formed on one surface 10A (which will hereinafter be referred to as a "non-irradiation surface") of an n-type silicon wafer 10, and a collector is formed on the other surface (which will hereinafter be referred to as a "laser irradiation surface") 10B.

For example, as illustrated in FIG. 1A, a p-type base region 11, an n-type emitter region 12, a gate electrode 13, a gate insulating film 14, and an emitter electrode 15 are disposed in an outer layer portion on the non-irradiation surface 10A of the silicon wafer 10. On-off control of a current can be performed by a voltage between the gate and the emitter. For example, aluminum is used for the emitter electrode 15.

A p-type collector layer 17 and an n-type buffer layer (field stop layer) 16 having a low density are formed in an outer layer portion on the laser irradiation surface 10B of the silicon wafer 10. The buffer layer 16 is disposed in a region deeper than the collector layer 17. The collector layer 17 is formed by performing ion-implantation of a p-type dopant, for example, boron (B) and activating the p-type dopant. The n-type buffer layer 16 is formed by implanting an n-type dopant, for example, phosphorus (P) and protons and activating the n-type dopant. Phosphorus is implanted in a relatively shallow region of the buffer layer 16, and protons are implanted in a relatively deep region. A collector electrode 18 is formed on an outer surface of the collector layer 17.

The depth to the interface between the collector layer 17 and the buffer layer 16 from the laser irradiation surface 10B is within a range of approximately 0.2 µm to approximately 0.5 µm, for example. The depth to the deepest position in the buffer layer 16 from the laser irradiation surface 10B is within a range of 5 µm to 40 µm, for example. It is difficult to implant phosphorus in a region deeper than 5 µm. Therefore, the region deeper than 5 µm is caused to be an n-type region by mainly activating protons.

FIG. 1B is a cross-sectional view of the silicon wafer 10 in a phase of performing laser annealing. Boron is implanted in a first layer 17a of the outer layer portion on the laser irradiation surface 10B of the silicon wafer 10. Phosphorus is implanted in a second layer 16a deeper than the first layer 17a, and protons are implanted in a third layer 16b deeper than the second layer 16a. In this phase, these dopants are not activated. The dose of boron is greater than the dose of phosphorus.

### [Step of manufacturing IGBT]

Next, a step of manufacturing an IGBT will be described. First, an element structure including the base region 11, the emitter region 12, the gate electrode 13, the gate insulating film 14, and the emitter electrode 15 (FIG. 1A) is formed on the non-irradiation surface 10A of a silicon wafer. The element structure of the non-irradiation surface 10A is formed by a known semiconductor process.

After an element structure is formed on the non-irradiation surface 10A, the silicon wafer 10 is thinned by grinding the silicon wafer 10 from the laser irradiation surface 10B. As an example, the silicon wafer 10 is thinned such that the thickness is within a range of 50 µm to 200 µm. Boron, phosphorus, and protons are implanted from the laser irradiation surface 10B of the thinned silicon wafer 10, so that the first layer 17a, the second layer 16a, and the third layer 16b (FIG. 1B) are formed. For example, an ion implantation method is applied for implantation of these dopants.

After the dopants are implanted, laser annealing is performed by causing a laser beam to be incident onto the laser irradiation surface 10B of the silicon wafer 10. Boron, phosphorus, and protons are activated through this laser annealing, and the p-type collector layer 17 and the n-type buffer layer 16 (FIG. 1A) are formed.

### [Preferable condition for activating protons]

Next, a preferable condition for activating protons implanted in the third layer 16b (FIG. 1B) through laser annealing will be described.

Before laser annealing is performed, an IGBT element structure is formed on the non-irradiation surface 10A of the silicon wafer 10 (FIG. 1A). When the temperature on the non-irradiation surface 10A becomes excessively high during laser annealing, the element structure is damaged. Specifically, in a case of using a metal material, such as aluminum, having a low melting point for the emitter electrode 15, silicide reaction or the like between this metal material and the silicon wafer 10 occurs. In order to minimize damage to the element structure, it is desirable that the highest temperature on the non-irradiation surface 10A during laser annealing is equivalent to or lower than the temperature (approximately 450°C) at which silicide reaction of aluminum occurs. To leave a margin, it is preferable that the highest temperature on the non-irradiation surface 10A is 400°C or lower.

There are cases where a dopant other than protons is added to a very shallow region in a silicon wafer. When the outer layer portion of a silicon wafer melts when protons are activated, turbulence occurs in a density distribution (profile) related to a depth direction of a dopant other than protons. In order to prevent turbulence of the profile of a dopant in a very shallow region, it is preferable to select a pulse width of a pulsed laser beam and a pulse energy density on the outer surface of a silicon wafer such that the highest temperature on the laser irradiation surface 10B does not exceed the melting point (1,414°C) of silicon.

When the pulse width is determined, the upper limit value for the pulse energy density for satisfying a condition that the laser irradiation surface 10B does not melt is determined. In order to activate protons in a deeper region, it is preferable that the highest temperature on the laser irradiation surface 10B becomes near the melting point of silicon. According to the invention, the pulse width and the pulse energy density are selected such that an irradiation surface of the highest temperature is within a range of 1,000°C to lower than 1,414°C.

Moreover, it is preferable that the pulse width and the pulse energy density of a pulsed laser beam are in a range in which a disorder generated in a proton passing region can be eliminated or reduced.

### [Process of heating in case of using laser beam having wavelength region with long intrusion length]

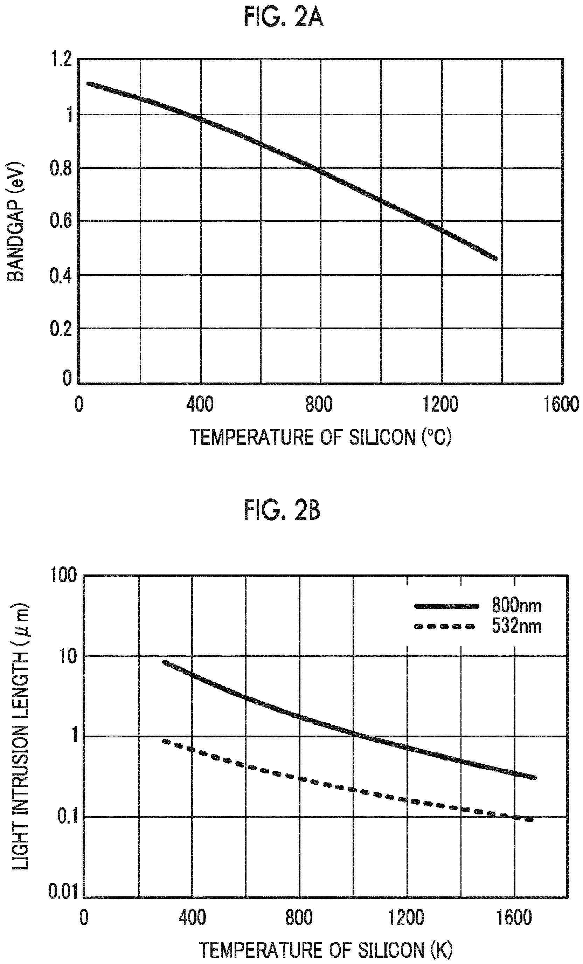

Next, for heating a region deeper than 5 µm in which protons are implanted, a process of heating in annealing using a laser beam having a wavelength region with a long intrusion length will be described with reference to FIGs. 2A to 3.

FIG. 2A is a graph illustrating a relationship between the temperature of silicon and a bandgap, and FIG. 2B is a graph illustrating a relationship between the temperature of silicon and a light intrusion length. In FIG. 2A, the horizontal axis expresses the temperature of silicon in the unit of "°C", and the vertical axis expresses the bandgap in the unit of "eV". In FIG. 2B, the horizontal axis expresses the temperature of silicon in the unit of "K", and the vertical axis expresses the light intrusion length in the unit of "µm". In FIG. 2B, the solid line and the dotted line respectively indicate the intrusion lengths of light having wavelengths of 800 nm and 532 nm.

As illustrated in FIG. 2A, the bandgap is narrowed in accordance with a rise in the temperature of silicon. Generally, the rate of light absorption increases in accordance with the bandgap being narrowed.

As illustrated in FIG. 2B, when the temperature of silicon rises, the bandgap is narrowed, so that the light intrusion length becomes short. At room temperature, the intrusion lengths of light having the wavelengths of 800 nm and 532 nm are approximately 10 µm and 1 µm, respectively. When the temperature of silicon rises to a temperature near the melting point (1687 K), the intrusion lengths of light having the wavelengths of 800 nm and 532 nm are respectively shortened to approximately 1/30 and approximately 1/10 of the intrusion length when being at room temperature.

When a laser beam having a wavelength of 800 nm with a long intrusion length is caused to be incident onto a silicon wafer at room temperature, the laser beam intrudes to a depth of approximately 10 µm. Incidentally, after the temperature on the outer surface of the silicon wafer rises to a temperature near the melting point, the intrusion length becomes shorter than the intrusion length of a laser beam having the wavelength of 532 nm at room temperature. In this manner, even if a laser beam having a wavelength with a long intrusion length at room temperature is used, the intrusion length becomes short after the temperature on the outer surface has risen. Therefore, even in a case of performing laser annealing using a laser beam having a wavelength with a long intrusion length, the laser energy is absorbed near the pole on the outer surface after the temperature on the outer surface has risen. Heat generated near the outer surface due to the absorbed laser energy is conducted to a deep region in a silicon wafer, so that the temperature in a deep region in the silicon wafer rises.

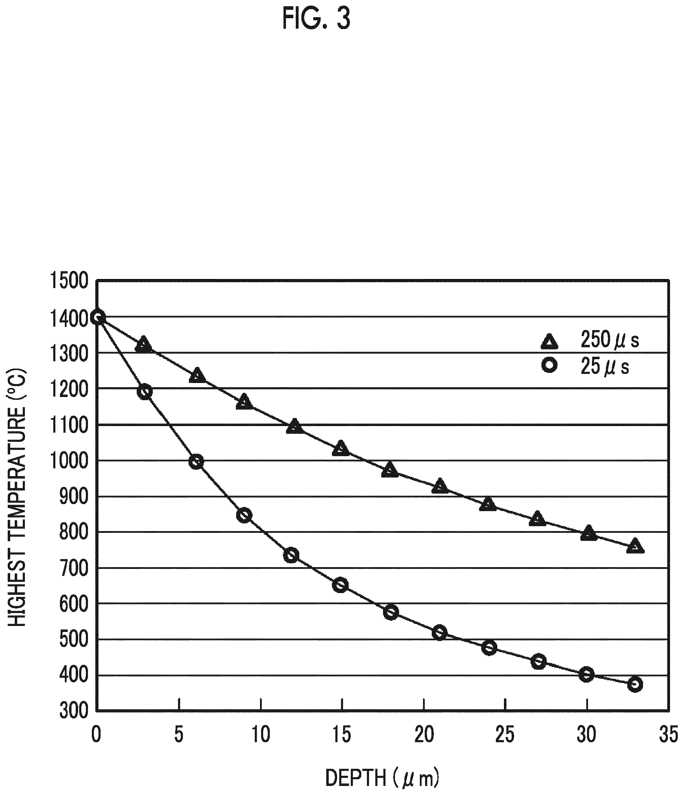

FIG. 3 is a graph illustrating a simulation result of a relationship between the depth and the highest temperature in a case where a laser beam is caused to be incident on condition that the highest temperature on an outer surface becomes the melting point (1,414°C) of silicon. The horizontal axis expresses the depth from the outer surface of a silicon wafer in the unit of "µm", and the vertical axis expresses the highest temperature in the unit of "°C". The wavelength of a pulsed laser beam to be incident onto the silicon wafer is set to 800 nm. The triangular symbols and the circular symbols in FIG. 3 respectively indicate the highest temperatures when one shot of pulsed laser beams having pulse widths of 250 µs and 25 µs are incident. In both the cases, the pulse energy density is adjusted such that the temperature on the outer surface at the time of falling of the pulse becomes approximately 1,414°C.

The highest temperature on the outer surface of a silicon wafer is the highest, and the highest temperature decreases as the region becomes deeper. When protons are implanted, a disorder is generated in the passing region shallower than the depth corresponding to a projection range Rp. As illustrated in FIG. 3, the highest temperature in a relatively shallow region, in which a disorder has been generated, becomes higher than the highest temperature in a relatively deep region in which protons are to be activated. In other words, an annealing temperature in a region in which a disorder is generated can become higher than the annealing temperature in a region at a depth corresponding to the projection range Rp of protons. In the embodiment described below, a temperature profile, in which the temperature in a shallow region becomes higher than the temperature in a deep region, is utilized.

### [Laser annealing method according to embodiment]

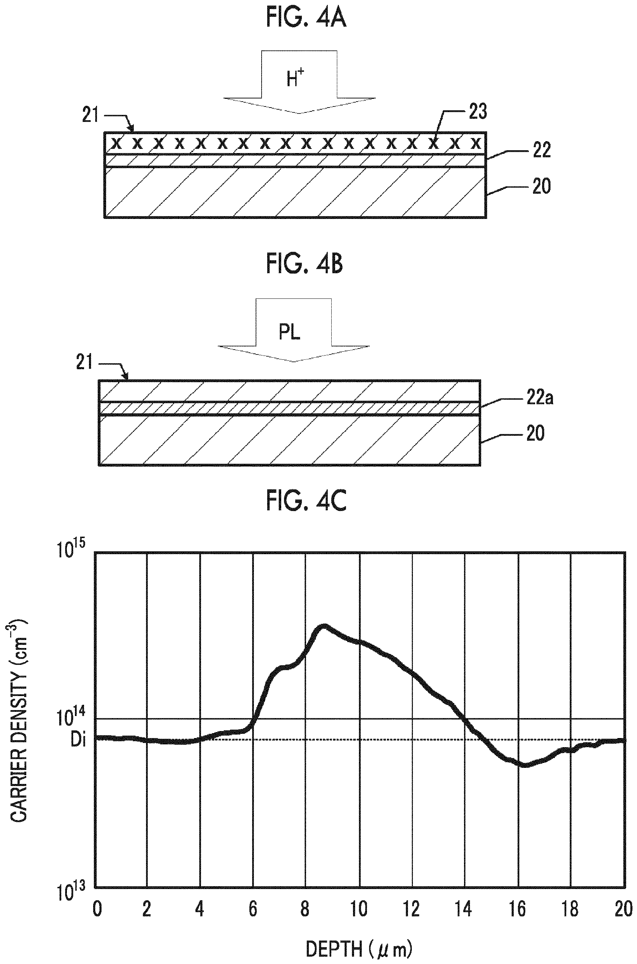

Next, with reference to FIGs. 4A to 4C, the laser annealing method according to the embodiment will be described.

FIG. 4A is a cross-sectional view of a silicon wafer 20 that is an annealing target. A donor is added to the entire region of the silicon wafer 20 in a thickness direction, and n-type conductivity is imparted to the silicon wafer 20. Protons H⁺ are implanted from one outer surface 21 of the silicon wafer 20 on condition that the projection range Rp becomes approximately 5 µm, and a proton-implanted layer 22 is formed. A disorder 23 is generated in the proton passing region shallower than the proton-implanted layer 22.

FIG. 4B is a cross-sectional view of the silicon wafer 20 after laser annealing. Laser annealing is performed by causing a pulsed laser beam PL having a wavelength of 808 nm to be incident onto the outer surface 21 of the silicon wafer 20. A semiconductor laser element can be used as a laser source. Through this laser annealing, protons within the proton-implanted layer 22 (FIG. 4A) are activated, and an n-type layer 22a is formed.

The pulse width of the pulsed laser beam PL and the pulse energy density on the outer surface of the silicon wafer 20 are set to a condition that the disorder 23 (FIG. 4A) is eliminated to recover the carrier density in the proton passing region to at least an initial donor concentration of a silicon wafer before protons are implanted and the highest temperature on the non-irradiation surface on a side opposite to the laser irradiation surface (outer surface 21) of the silicon wafer 20 does not exceed 400°C. Here, the "initial donor concentration" denotes a concentration of an electrically activated n-type dopant of n-type dopants which are doped when silicon ingot of single crystal is formed.

Next, with reference to FIG. 4C, excellent effects of the present embodiment will be described.

FIG. 4C is a graph illustrating a distribution of the carrier density related to the thickness direction of the silicon wafer 20 after laser annealing. The horizontal axis expresses the depth from the outer surface 21 of the silicon wafer 20 in the unit of "µm", and the vertical axis expresses the carrier density (carrier concentration) in the unit of "cm-³". In FIGs. 4A to 4C, the dotted line indicates an initial donor concentration Di of the silicon wafer 20.

In the range of the depth of 5 µm to 14 µm, the n-type carrier density is higher than the initial donor concentration Di. It denotes that protons are activated. Moreover, the carrier density in a region shallower than the depth of 5 µm (proton passing region) is substantially equivalent to the initial donor concentration Di. That is, the carrier density in the proton passing region has not decreased. It denotes that most of the disorder 23 (FIG. 4A) is eliminated through laser annealing.

In the present embodiment, as seen from the distribution of the highest temperature illustrated in FIG. 3, the annealing temperature in the proton passing region becomes higher than the annealing temperature in a region in which protons are to be activated. Accordingly, the disorder 23 can be efficiently eliminated. Moreover, as illustrated in FIG. 3, the highest temperature on the non-irradiation surface on a side opposite to the outer surface 21 (FIG. 4A) irradiated with a laser is lower than the highest temperature on the outer surface 21 or the proton-implanted layer 22. Therefore, it is possible to find a laser irradiation condition for the temperature on the non-irradiation surface on which the highest temperature does not exceed 400°C and protons can be activated.

Next, various modification examples of the present embodiment will be described. In the present embodiment, a pulsed laser beam having a wavelength of 808 nm is used. However, a different pulsed laser beam having a wavelength in an infrared region, for example, a wavelength of 690 nm to 950 nm may be used. In addition, in the present embodiment, protons are implanted in the silicon wafer 20. Alternatively, an element forming a complex defect that serves as a donor by being activated, for example, deuteron or triton may be used.

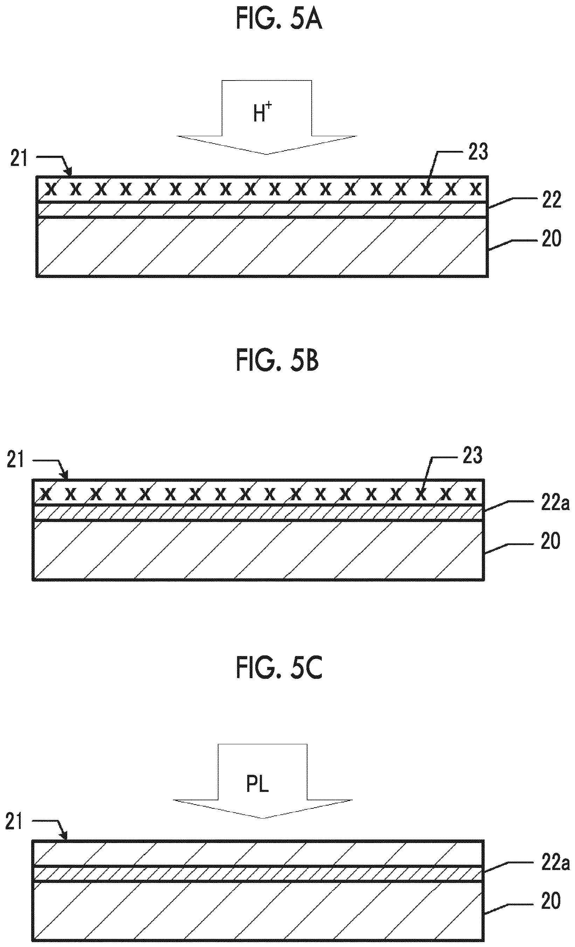

Next, with reference to FIGs. 5A to 5C, a laser annealing method according to another embodiment will be described. In the embodiment illustrated in FIGs. 4A to 4C, protons are activated and a disorder is eliminated through laser annealing. In the present embodiment, furnace annealing is used to activate protons, and laser annealing is used to eliminate the disorder.

FIG. 5A is a cross-sectional view of the silicon wafer 20 after protons are implanted. The state thereof is the same as the cross-sectional view of the silicon wafer 20 illustrated in FIG. 4A. The disorder 23 is generated in the proton passing region.

FIG. 5B is a cross-sectional view of the silicon wafer 20 after furnace annealing. Protons within the proton-implanted layer 22 (FIG. 5A) are activated and the n-type layer 22a is formed by performing furnace annealing. It is difficult to eliminate the disorder 23 through furnace annealing. Therefore, the disorder 23 remains in the proton passing region even after furnace annealing.

FIG. 5C is a cross-sectional view of the silicon wafer 20 after laser annealing. The disorder 23 (FIG. 5B) can be eliminated by performing laser annealing.

In the embodiment illustrated in FIGs. 4A to 4C, it is necessary to perform both activation of protons through laser annealing and elimination of the disorder 23. In contrast, in the embodiment illustrated in FIGs. 5A to 5C, since it is not necessary to perform activation of protons through laser annealing, the laser irradiation condition is alleviated. In this manner, a preferable laser irradiation condition in a case of using the laser annealing method according to the embodiment illustrated in FIGs. 5A to 5C in parallel with furnace annealing is different from a preferable laser irradiation condition in a case of using the laser annealing method according to the embodiment illustrated in FIGs. 4A to 4C not using furnace annealing.

### [Laser irradiation condition for activating protons through laser annealing]

Next, a preferable condition for a beam size, a laser oscillation form, and a pulse width (heating time) for activating protons through laser annealing and eliminating a disorder without using furnace annealing in parallel therewith on condition that the highest temperature on the laser irradiation surface 10B of the silicon wafer 10 reaches a temperature slightly lower than approximately 1,414°C that is the melting point of silicon will be described.

### [Preferable condition for beam size]

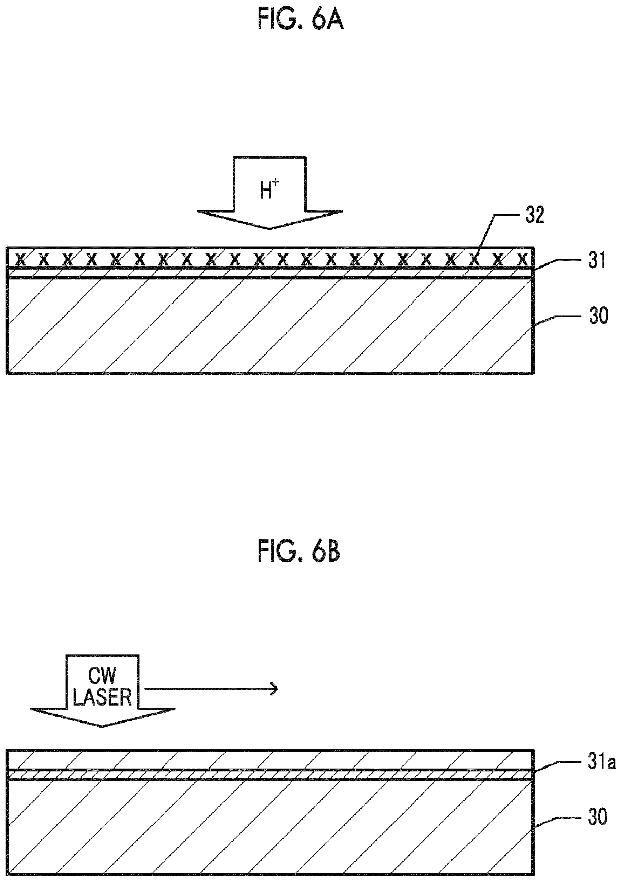

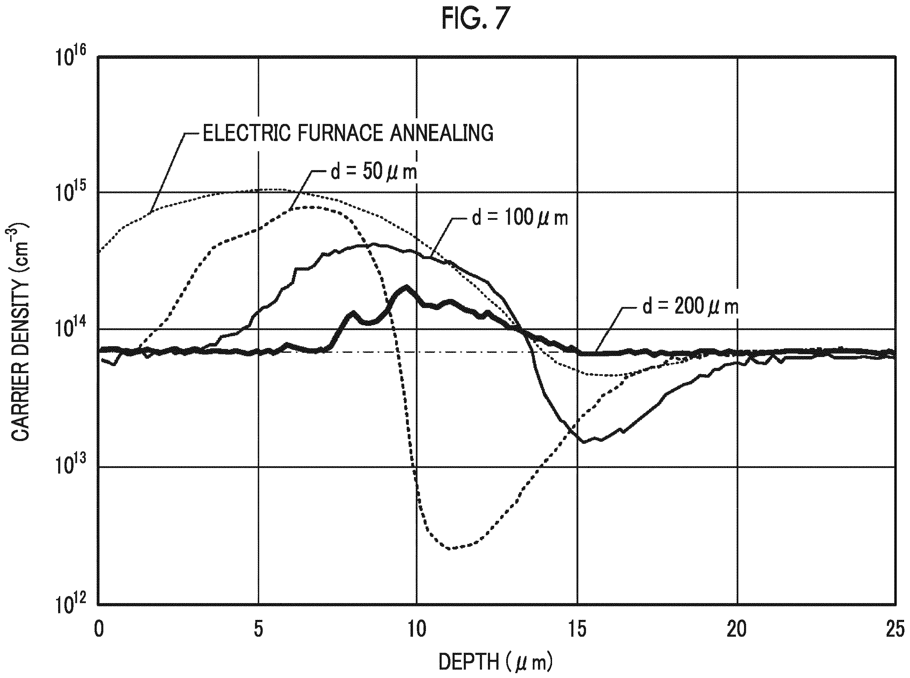

With reference to FIGs. 6A, 6B, and 7, a preferable condition for the beam size will be described. When a laser beam is incident onto a silicon wafer, light energy is absorbed by the outer layer portion of the silicon wafer and is converted into heat. Then, the heat diffused into a deep portion. In order to activate protons implanted in a deep region at a depth of approximately 10 µm, it is necessary to efficiently diffuse heat toward the deep portion.

The inventor of this application has performed an evaluation experiment for examining a relationship between the beam size on the outer surface of a silicon wafer and activation of protons. Hereinafter, this evaluation experiment will be described.

FIG. 6A is a cross-sectional view of a silicon wafer 30 used in the evaluation experiment. Protons are implanted in the silicon wafer 30 on condition of the dose of 1×10¹⁴ cm-², and a proton-implanted layer 31 is formed. A beam of protons to be implanted can be obtained by performing acceleration with acceleration energy of 4.3 MeV, for example, and then performing deceleration using aluminum foil such that the projection range Rp becomes 5 µm. A disorder 32 is generated in the proton passing region.

FIG. 6B is a cross-sectional view of the silicon wafer 30 after laser annealing. Protons are activated within the proton-implanted layer 31 (FIG. 6A), so that an n-type layer 31a is formed. Moreover, the disorder 32 (FIG. 6A) is eliminated. A continuous oscillation laser having a wavelength of 808 nm is used for laser annealing. The diameter of a beam spot of a laser beam on the outer surface of the silicon wafer 30 is set on three conditions of 50 µm, 100 µm, and 200 µm. The moving speed of the beam spot is adjusted such that the heating time of the silicon wafer 30 becomes 200 µs. The power density on the outer surface of the silicon wafer 30 is set such that the highest temperature on the outer surface of the silicon wafer 30 becomes equivalent to the melting point of silicon (approximately 1,414°C). Even though the size of the beam spot varies, the heating time is uniform. Therefore, the power density satisfying the condition described above is uniform.

FIG. 7 is a graph illustrating a measurement result of a distribution of the carrier density of the silicon wafer 30 after laser annealing related to the depth direction. The distribution of the carrier density is measured by using a spreading resistance measuring method (SRA). In FIG. 7, the horizontal axis expresses the depth from the outer surface in the unit of "µm", and the vertical axis expresses the carrier density in the unit of "cm⁻³". In FIG. 7, the thick dotted line, the thin solid line, and the thick solid line respectively indicate the carrier densities of samples subjected to laser annealing on condition of diameters d of the beam spots are 50 µm, 100 µm, and 200 µm. It is ascertained that a significant difference is present among behaviors of activated protons depending on the size of the beam spot. For comparison, the carrier density of a sample subjected to annealing for approximately two hours at a temperature in a range of 350°C to 500°C by using an electric furnace is indicated with the thin dotted line. In addition, the initial donor concentration of the silicon wafer 30 is indicated with a one-dot chain line.

It is assumed that the carrier density distribution in a case of performing annealing using the electric furnace is close to the concentration distribution of the implanted protons. However, in the range of the depth of 14 µm to 20 µm, the carrier density has become lower than the initial donor concentration. This is resulted from an EOR defect generated due to ion-implantation. In order to eliminate an EOR defect through annealing using the electric furnace, the annealing temperature has to be increased. However, when the annealing temperature is increased, a complex defect serving as a donor is also eliminated. Therefore, it is difficult to eliminate an EOR defect through annealing using the electric furnace.

In a case where laser annealing is performed on condition that the diameter d of the beam spot is 50 µm, activation of protons proceeds in a region shallower than the depth of approximately 9 µm. However, protons are not activated at all in a region deeper than 9 µm. In a case where laser annealing is performed on condition that the diameter d of the beam spot is 200 µm, protons are activated in a range of the depth of 7 µm to 15 µm. Moreover, it is ascertained that an EOR defect within a range of the depth of 14 µm to 20 µm is eliminated. The behavior of activated protons in a case where laser annealing is performed on condition that the diameter d of the beam spot is 100 µm is in the middle of the behavior in a case where annealing is performed on condition that the diameter of the beam spot is 50 µm and the behavior in a case where annealing is performed on condition of 200 µm.

It is assumed that the activation fraction of protons becomes low in a region shallower than the depth of 7 µm in a case where annealing is performed on condition that the diameter d of the beam spot is 200 µm because the temperature in a shallow region becomes excessively high and the complex defect serving as a donor is recovered.

From the result of the evaluation experiment illustrated in FIG. 7, it is ascertained that when the beam spot is reduced, activation of protons in a deep region does not proceed. As a reason thereof, it is assumed that in a case where the beam spot is small, heat applied to the outer layer portion is diffused not only in the depth direction but also in a lateral direction, so that it is difficult for the temperature in a deep region to be increased.

In order to efficiently activate protons in a region deeper than 10 µm, it is preferable that the diameter of the beam spot is set to 100 µm or larger. Moreover, in order to efficiently eliminate an EOR defect, it is preferable that the diameter of the beam spot is set to 200 µm or larger.

In this evaluation experiment, the beam spot has a circular shape. However, even in a case of performing annealing while the beam spot has a long shape elongated in one direction, the result of the evaluation experiment described above can be applied. For example, in order to activate protons in a region deeper than 10 µm, it is preferable that the width of the beam spot having a long shape is set to 100 µm or larger. In order to eliminate an EOR defect, it is preferable that the width of the beam spot having a long shape is set to 200 µm or larger.

In a case where protons cannot be efficiently activated, the energy density of a laser beam for irradiation has to be increased. When the energy density of a laser beam is increased, the temperature on the non-irradiation surface 10A of a silicon wafer (FIG. 1B) increases. In order to suppress a rise in temperature on the non-irradiation surface 10A, it is desirable that the efficiency of annealing for activating protons is raised. The efficiency of annealing for activating protons can be raised by setting the width of the beam spot to 200 µm or larger.

### [Preferable condition for laser oscillation form]

Next, a preferable condition for a laser oscillation form will be described. In a case of performing annealing using a continuous oscillation laser, the heating time is determined based on the size of the beam spot and the moving speed on the outer surface of a silicon wafer. In annealing using a continuous oscillation laser, the silicon wafer is irradiated with a laser at all times. Therefore, the temperature of the silicon wafer can be easily increased. In other words, the temperature on the non-irradiation surface easily rises as well. In contrast, in a case of using a pulse laser, the heating time is determined based on the pulse width. When the duty ratio of laser oscillation is reduced, heat accumulated in a silicon wafer can be reduced. Therefore, it is possible to suppress a rise in temperature on the non-irradiation surface.

The highest temperature on the non-irradiation surface is obtained through simulation on condition that the temperature on the laser irradiation surface of a silicon wafer having a thickness of 125 µm is heated to the melting point of silicon. As a result, the highest temperature on the non-irradiation surface in a case of using a continuous oscillation laser is 640°C, and the highest temperature on the non-irradiation surface in a case of using a pulse laser having a pulse width of 10 µs and an oscillation duty ratio of 2% is 150°C. The difference between the temperatures is caused because the temperature is significantly affected by the accumulated heat in a case of using a continuous oscillation laser but the temperature is unlikely to be affected by the accumulated heat in a case of using a pulse laser.

As described above, it is ascertained that it is difficult to cause the highest temperature on the laser irradiation surface to be near the melting point of silicon and to cause the highest temperature on the non-irradiation surface of a silicon wafer to be 400°C or lower in a case of using a continuous oscillation laser. In order to cause the highest temperature on the non-irradiation surface to be 400°C or lower, it is preferable that a pulse laser is used. In order to reduce the influence of accumulated heat, it is preferable that the duty ratio of oscillation is 10% or lower and it is more preferable to be 5% or lower.

### [Preferable condition for pulse width]

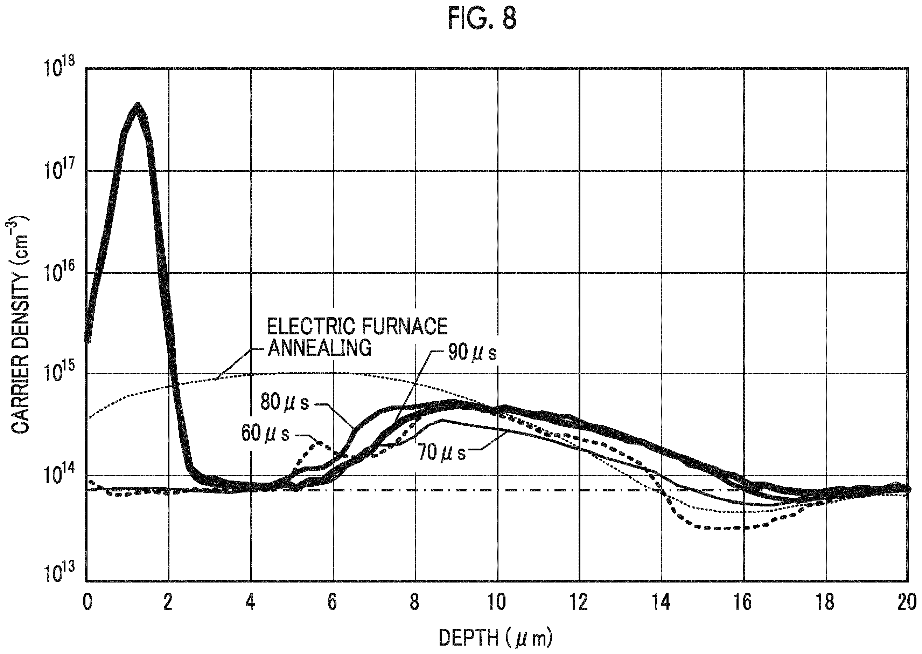

Next, with reference to FIGs. 8 to 10, a preferable condition for a pulse width will be described. Laser annealing is performed on condition of four pulse widths of 90 µs, 80 µs, 70 µs, and 60 µs, and an evaluation experiment measuring the carrier density distribution related to the depth direction is performed. A silicon wafer, in which protons are implanted on condition that the dose is set to 1×10¹⁴ cm⁻² and the projection range Rp is set to 5 µm, is used.

The beam spot on the laser irradiation surface of the silicon wafer has a circular shape with a diameter of 200 µm. In addition, the pulse energy density is selected such that the highest temperature on the laser irradiation surface becomes near the melting point of silicon. For example, in a case where the pulse width is 90 µs, the pulse energy density becomes 18.8 J/cm². When the pulse width becomes short, the pulse energy density necessary for the highest temperature on the outer surface of a silicon wafer to be near the melting point of silicon decreases. In other words, when the pulse width is widened, the pulse energy density for the highest temperature on the outer surface of a silicon wafer to be near the melting point of silicon increases. The reason is that the quantity of heat diffused to the inside and the outside of the silicon wafer increases when the pulse width is widened.

FIG. 8 is a graph illustrating a measurement result of a distribution of the carrier density related to the depth direction of samples subjected to laser annealing under the condition described above. The horizontal axis expresses the depth in the unit of "µm", and the vertical axis expresses the carrier density in the unit of "cm⁻³". In FIG. 8, the thickest solid line, the subsequently thickest solid line, the thin solid line, and the thick dotted line respectively indicate measurement results of the samples subjected to laser annealing on condition of the pulse widths of 90 µs, 80 µs, 70 µs, and 60 µs. For comparison, the measurement result of a sample subjected to electric furnace annealing is indicated with the thin dotted line, and the n-type carrier density of the base of the silicon wafer is indicated with a one-dot chain line.

In the samples which have the pulse widths of 90 µs and 80 µs and are subjected to laser annealing, phosphorus is implanted in a shallow region of the outer layer portion. The peak of the carrier density in a region shallower than the depth of 3 µm is resulted from the implanted phosphorus.

In laser annealing using a pulse laser, it is ascertained that most of protons are not activated in a region shallower than the depth of 5 µm. As a reason thereof, it is assumed that a complex defect serving as a donor is recovered through laser annealing. In order to increase the n-type carrier density in a region shallower than the depth of 5 µm, a substitution n-type dopant, for example, phosphorus may be implanted and the substitution n-type dopant may be activated.

In a range of the depth of 14 µm to 18 µm, the carrier densities of a sample subjected to electric furnace annealing and a sample subjected to laser annealing on condition of the pulse width of 60 µs are lower than the carrier density of a base. It denotes that an EOR defect generated during ion-implantation still remains even after annealing. In a sample subjected to laser annealing on condition of the pulse width of 70 µs, an EOR defect slightly remains in a range of the depth of 16 µm to 17 µm. However, compared to a case of electric furnace annealing, the density of the EOR defect is low. In a sample subjected to laser annealing on condition of the pulse width of 80 µs and 90 µs, it is ascertained that most of EOR defect is eliminated. In order to eliminate an EOR defect, according to the invention, the pulse width is set to 70 µs or larger.

It is possible to activate protons within a range of the depth of 5 µm to 15 µm by performing laser annealing on condition of the pulse width of 70 µs. It is possible to activate protons within a range of the depth of 5 µm to 20 µm by performing laser annealing on condition of the pulse width of 80 µs to 90 µs. Particularly, within a range of the depth of 10 µm to 17 µm, the activation fraction of protons can be further increased by performing laser annealing, compared to a case of performing electric furnace annealing.

In the evaluation experiment illustrated in FIG. 8, the beam spot on the outer surface of a silicon wafer has a circular shape with a diameter of 200 µm. As illustrated in FIG. 7, when the diameter of the beam spot is set to 50 µm, protons in a region shallower than the depth of 5 µm can also be activated. For example, protons in a region of the depth of 2 µm to 9 µm can be activated.

The activation fraction of protons in a case of performing electric furnace annealing depends on the annealing temperature and the annealing time. In contrast, in laser annealing using a pulse laser, the temperature starts to rise from the time of rising of a pulsed laser beam, and the temperature falls from the time of falling thereof. The behavior of a time change of the temperature scarcely depends on the pulse width within a range of the pulse width of 60 µs to 90 µs illustrated in FIG. 8. Therefore, it is assumed that the activation fraction of protons in annealing using a pulse laser depends on the highest temperature.

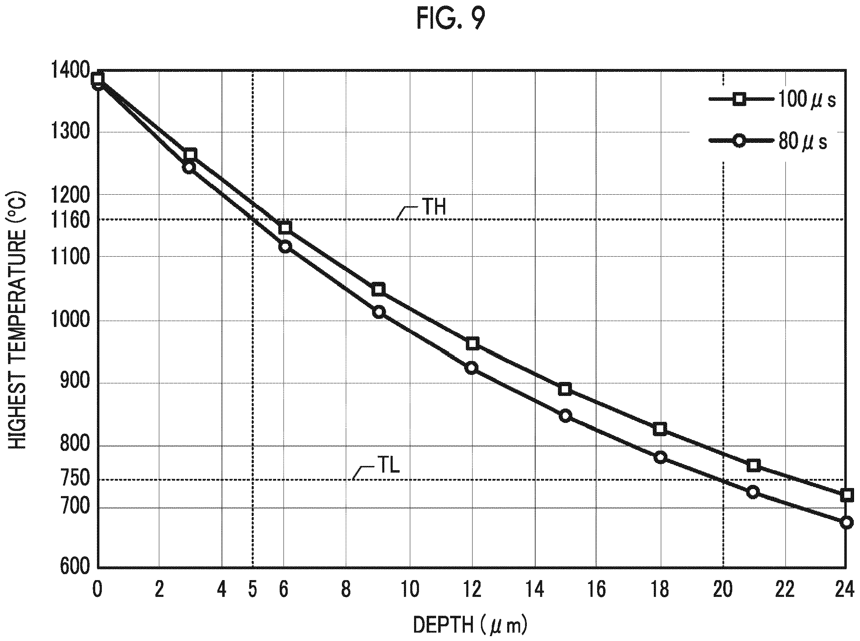

FIG. 9 is a graph illustrating a simulation result of a distribution of the highest temperature related to the depth direction in a case of performing laser annealing on condition that the highest temperature on the outer surface of a silicon wafer substantially reaches the melting point of silicon. The horizontal axis expresses the depth in the unit of "µm", and the vertical axis expresses the highest temperature in the unit of "°C". In FIG. 9, the circular symbols and the quadrangular symbols respectively indicate the highest temperatures when the pulse width is 80 µs and 100 µs.

As described with reference to FIG. 8, in a sample subjected to laser annealing on condition of the pulse width of 80 µs, protons are activated within a range of the depth of 5 µm to 20 µm. As seen from FIG. 9, the highest temperatures at positions of the depths of 5 µm and 20 µm at the time of irradiation of a laser having a pulse width of 80 µs are approximately 1,160°C and approximately 750°C, respectively. Based on this fact, it is assumed that an upper limit value TH for a preferable range of the highest temperature for activating protons is 1,160°C and a lower limit value TL therefor is 750°C.

As seen from FIG. 8, it is ascertained that a high activation fraction can be obtained in a region deeper than the depth of 10 µm, compared to the activation fraction through electric furnace annealing. The highest temperature at a position of the depth of 10 µm is approximately 1,000°C. That is, a high activation fraction can be obtained in a region deeper than a position at which the highest temperature becomes 1, 000°C, compared to the activation fraction through electric furnace annealing. From the viewpoint of obtaining an activation fraction higher than the activation fraction through electric furnace annealing, the upper limit value TH for a preferable range of the highest temperature may be set to 1,000°C.

It is possible to activate protons between the upper limit value TH and the lower limit value TL for a preferable range of the highest temperature illustrated in FIG. 9. In a case of performing annealing on condition of the pulse width of 100 µs, the depth at which the highest temperature is settled between the upper limit value TH and the lower limit value TL ranges from 6 µm to 19.5 µm. Therefore, when annealing is performed on condition of the pulse width of 100 µs, it is possible to activate protons in a range of the depth of 6 µm to 19.5 µm. On the contrary, a preferable pulse width can be obtained from a range of a target depth at which protons are intended to be activated, based on the graph illustrated in FIG. 9.

In the examples illustrated in FIGs. 7 and 8, it is difficult to activate protons in a region shallower than the depth of 2 µm through laser annealing. The reason is that laser annealing is performed on condition that the highest temperature on the laser irradiation surface becomes near the melting point of silicon in order to activate protons in a deeper region. When the condition for laser annealing is set such that the highest temperature on the laser irradiation surface is within a range between the upper limit value TH and the lower limit value TL, it is also possible to activate protons in a shallow region to the depth of 2 µm from the outer surface.

Next, a preferable range for a pulse width derived from a condition that the highest temperature on the non-irradiation surface of a silicon wafer is set to 400°C or lower will be described.

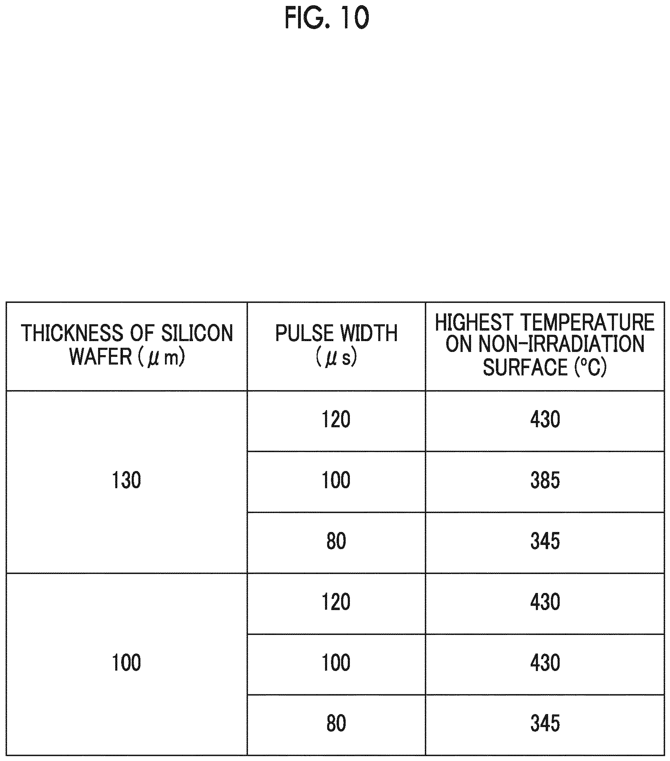

FIG. 10 is a table showing a simulation result of a relationship among a thickness of a silicon wafer, a pulse width, and the highest temperature on a non-irradiation surface. The highest temperature on the non-irradiation surface is obtained with respect to two kinds of silicon wafers having thicknesses of 100 µm and 130 µm and three kinds of pulse widths of 80 µs, 100 µs, and 120 µs. The pulse energy density is set such that the highest temperature on the laser irradiation surface becomes near the melting point of silicon.

The non-irradiation surface is coated with an irreversible temperature-indicating ink, and the highest temperature on the non-irradiation surface is obtained from the color change of the temperature-indicating ink. For example, in a case where the color of the temperature-indicating ink at the color-change temperature of 360°C has changed and the color of the temperature-indicating ink at the color-change temperature of 410°C has not changed, it is assumed that the highest temperature is within a range of 360°C to 410°C.

Under the condition that the highest temperature on the laser irradiation surface becomes near the melting point of silicon, the highest temperature on the non-irradiation surface depends on the pulse width and the thickness of a silicon wafer. As illustrated in FIG. 10, when the pulse width is widened, the highest temperature on the non-irradiation surface increases, and when a silicon wafer is thinned, the highest temperature on the non-irradiation surface increases.

In a case where the thickness of a silicon wafer is 130 µm, the highest temperature on the non-irradiation surface becomes 400°C or lower on condition that the pulse width is 100 µs or smaller. In a case where the thickness of a silicon wafer is 100 µm, the highest temperature on the non-irradiation surface becomes 400°C or lower on condition that the pulse width is 80 µs or smaller. The IGBT tends to be thinned in order to improve electrical characteristics, so that the thickness of a silicon wafer in a phase of performing annealing for activating protons is often set to 130 µm or smaller. Therefore, according to the invention, pulse width of a pulsed laser beam used in laser annealing is selected from a range of 100 µs or smaller.

Even if the thickness of a silicon wafer is thinner than 100 µm, in a case where a target depth at which protons are to be activated is shallower than 20 µm shallower, the highest temperature on the non-irradiation surface can be restricted to 400°C or lower. On the contrary, if the thickness of a silicon wafer is thicker than 130 µm, the highest temperature on the non-irradiation surface can be restricted to 400°C or lower, and protons in a region deeper than 20 µm can be activated. In this manner, the temperature on the non-irradiation surface is affected by the thickness of a silicon wafer or the depth of the region in which protons are intended to be activated. The foregoing relationship among the thickness of a silicon wafer, the pulse width, and the highest temperature on the non-irradiation surface is an example and varies depending on the design of the device.

The upper limit value for the pulse width at which the highest temperature on the non-irradiation surface becomes 400°C or lower can be determined in advance through simulation or the like, in accordance with the thickness of a silicon wafer. In a case of performing annealing for activating protons, it is possible to determine the pulse width of a pulsed laser beam to be actually used, from a range of the upper limit value for the pulse width or lower determined in accordance with the thickness of a silicon wafer.

The evaluation experiments and simulation described above are performed by setting the wavelength of a pulsed laser beam to 808 nm. However, based on determination from an absorption spectrum of silicon, it is possible to apply a similar annealing condition using a pulsed laser beam within a range of the wavelength of 690 nm to 950 nm. In addition, in the study based on the evaluation experiments and simulation described above, an example of generating an n-type carrier by implanting protons has been described. However, an element other than protons forming a complex defect serving as a donor may be implanted. For example, deuteron or tritron may be implanted.

### [Method of manufacturing IGBT]

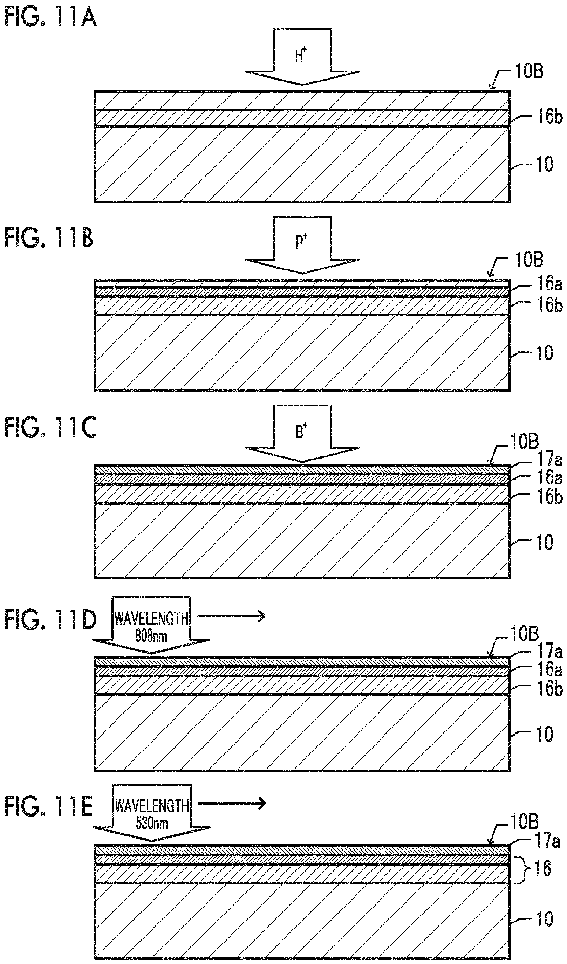

Next, with reference to FIGs. 1A and 11A to 11E, a method of manufacturing an IGBT will be described focusing on a step of forming a collector layer and a buffer layer. As illustrated in FIG. 1A, an element structure constituted of the base region 11, the emitter region 12, the gate electrode 13, the gate insulating film 14, and the emitter electrode 15 is formed on the non-irradiation surface 10A of the silicon wafer 10. After the element structure is formed, the thickness is reduced to a range of 50 µm to 200 µm by grinding the laser irradiation surface 10B of the silicon wafer 10.

As illustrated in FIG. 11A, protons are implanted in the outer layer portion on the laser irradiation surface 10B of the silicon wafer 10. For example, the dose of protons is set to 1×10¹⁴ cm⁻², and implantation is performed on condition that protons are distributed in a range to the depth of 20 µm from the outer surface. Accordingly, the third layer 16b in which protons are implanted is formed. During implantation of protons, ion-implantation may be performed a plurality of times with a plurality of kinds of acceleration energy.

As illustrated in FIG. 11B, phosphorus is implanted in the outer layer portion on the laser irradiation surface 10B of the silicon wafer 10. The depth for implantation of phosphorus is shallower than the third layer 16b. Accordingly, the second layer 16a in which phosphorus is implanted is formed.

As illustrated in FIG. 11C, boron is implanted in the outer layer portion on the laser irradiation surface 10B of the silicon wafer 10. The depth for implantation of boron is shallower than the second layer 16a. Accordingly, the first layer 17a in which boron is implanted is formed.

As illustrated in FIG. 11D, laser annealing is performed by causing a pulsed laser beam having a wavelength of 808 nm to be incident onto the laser irradiation surface 10B of the silicon wafer 10. Through this laser annealing, protons implanted in the third layer 16b and phosphorus implanted in the second layer 16a are activated, and the buffer layer 16 (FIG. 1A) is formed. A part of boron implanted in the first layer 17a is also activated. This laser annealing is performed on condition that the highest temperature on the non-irradiation surface 10A of the silicon wafer 10 (FIG. 1A) is 400°C or lower, the highest temperature on the laser irradiation surface 10B is equivalent to the melting point of silicon or lower, and at least protons in a part of a region to the depth of 20 µm from the outer surface are activated.

As illustrated in FIG. 11E, a pulsed laser beam having a green wavelength region, for example not covered by the subject-matter of the claims, a wavelength of 530 nm is caused to be incident onto the laser irradiation surface 10B of the silicon wafer 10, so that boron implanted in the first layer 17a is activated. Accordingly, the p-type collector layer 17 (FIG. 1A) is formed.

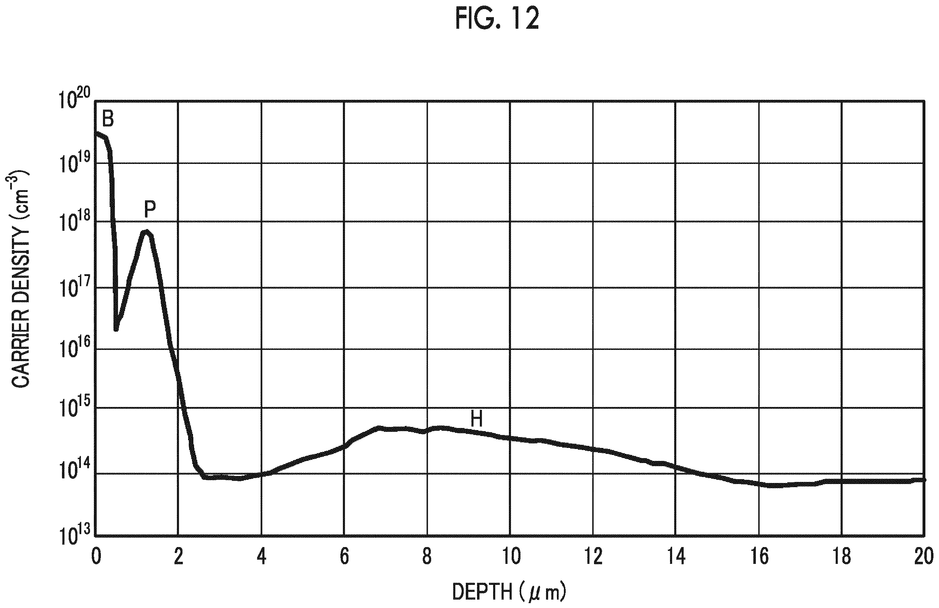

FIG. 12 illustrates a measurement result of a distribution of the carrier density in the outer layer portion on the laser irradiation surface 10B of the silicon wafer 10. The horizontal axis expresses the depth in the unit of "µm", and the vertical axis expresses the carrier density in the unit of "cm-³". A peak of a p-type carrier density at which boron is activated appears in a region shallower than the depth of 0.5 µm, and a peak an n-type carrier density at which phosphorus is activated appears in a range of the depth of 0.5 µm to 2 µm. A broad ridge of the n-type carrier density at which protons are activated appears in a range of the depth of 4 µm to 16 µm.

The depth of an n-type region which can be formed by implanting phosphorus is approximately 5 µm at most. An n-type region can be formed in a region deeper than 5 µm by implanting protons.

In the present embodiment, protons are implanted after grinding the laser irradiation surface 10B of the silicon wafer 10. However, the order of steps may be switched, such that the laser irradiation surface 10B of the silicon wafer 10 is ground after a plurality of steps from when protons are implanted.

### [Another method of manufacturing IGBT]

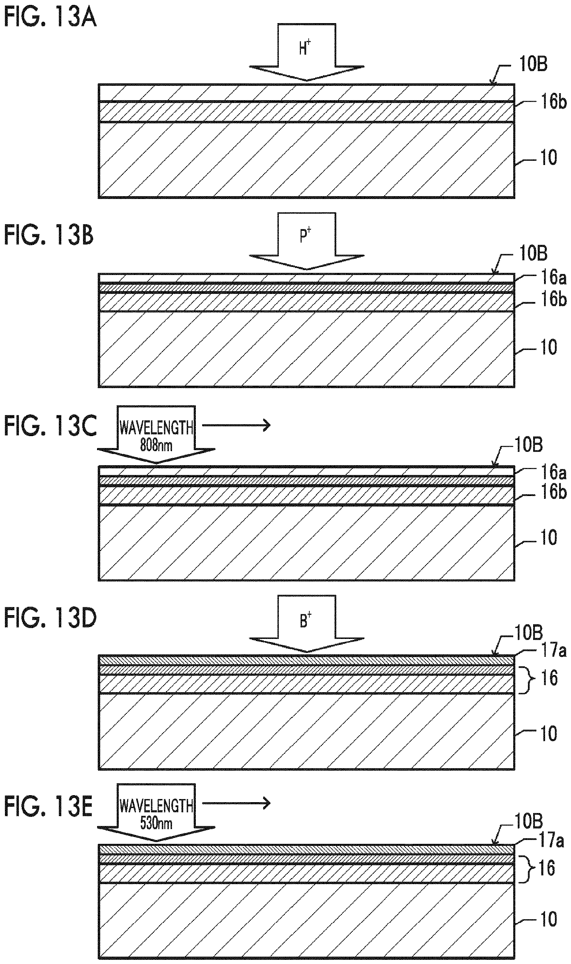

Next, with reference to FIGs. 13A to 13E, another method of manufacturing an IGBT will be described. Hereinafter, the difference between this method and the manufacturing method illustrated in FIGs. 11A to 11E will be described, and description of common steps will be omitted.

A step of implanting protons illustrated in FIGs. 13A and 13B and a step of implanting phosphorus are the same as the step illustrated in FIGs. 11A and 11B. In the method illustrated in FIGs. 11A to 11E, boron is implanted after implantation of phosphorus. In this method, as illustrated in FIG. 13C, laser annealing for activating protons and phosphorus is performed before implantation of boron. The annealing condition is the same as the condition for laser annealing illustrated in FIG. 11D.

As illustrated in FIG. 13D, after laser annealing for activating protons, boron is implanted in the outer layer portion on the laser irradiation surface 10B of the silicon wafer 10. The condition for implanting boron is the same as the condition for the step of implanting boron illustrated in FIG. 11C. As illustrated in FIG. 13E, laser annealing for activating boron is performed by using a pulsed laser beam having a green wavelength region.

As illustrated in FIGs. 13A to 13E, boron may be implanted after protons and phosphorus are activated.

### [Laser annealing device]

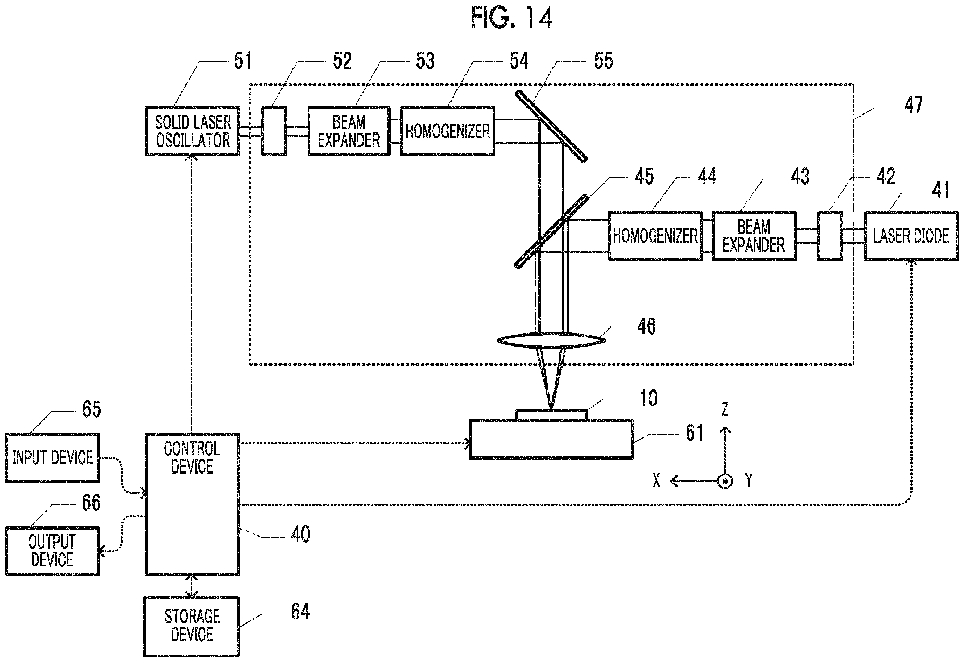

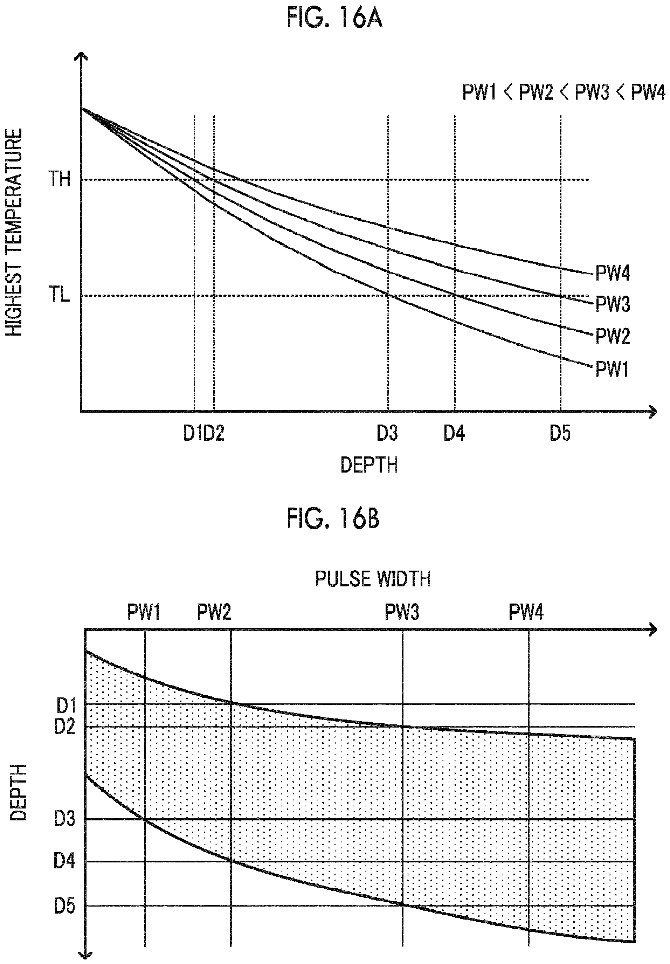

Next, with reference to FIGs. 14 to 16B, a laser annealing device according to the embodiment will be described.

FIG. 14 is a schematic view of the laser annealing device according to the embodiment. In this laser annealing device, as a laser source, a laser diode 41 and a solid laser oscillator 51 are mounted. The laser diode 41 outputs a first pulsed laser beam having a wavelength of 808 nm, for example. A laser diode which outputs a pulsed laser beam having a wavelength of 690 nm to 950 nm may be used. In addition, a laser diode which can perform continuous oscillation may be used as the laser diode 41, such that a pulsed laser beam is output by cyclically turning on and off a power supply circuit of the laser diode in a short period of time. The solid laser oscillator 51 outputs a second pulsed laser beam having a green wavelength region. For example, Nd: a YAG laser, Nd: a YLF laser, Nd: a YVO₄ laser, or the like outputting a second higher harmonic wave is used as the solid laser oscillator 51.

The first pulsed laser beam output from the laser diode 41 and the second pulsed laser beam output from the solid laser oscillator 51 are incident onto the silicon wafer 10 that is an annealing target via a propagation optical system 47.

Next, the configuration and operations of the propagation optical system 47 will be described. The first pulsed laser beam output from the laser diode 41 is reflected by a dichroic mirror 45 via an attenuator 42, a beam expander 43, and a homogenizer 44. Thereafter, the first pulsed laser beam is incident onto the silicon wafer 10 via a condensing lens 46.

The second pulsed laser beam output from the solid laser oscillator 51 is transmitted through the dichroic mirror 45 via an attenuator 52, a beam expander 53, a homogenizer 54, and a bending mirror 55. Thereafter, the second pulsed laser beam is incident onto the silicon wafer 10 via the condensing lens 46.

The beam expanders 43 and 53 respectively collimate the first pulsed laser beam and the second pulsed laser beam which have been incident and expand the beam diameters. The homogenizers 44 and 54 and the condensing lens 46 shape the beam cross-section on the outer surface of the silicon wafer 10 into a long shape and cause the distribution of light intensity within the beam cross-section to be uniform. The first pulsed laser beam output from the laser diode 41 and the second pulsed laser beam output from the solid laser oscillator 51 are incident into substantially the same long region on the outer surface of the silicon wafer 10. The width of this long region is 200 µm or larger.

The silicon wafer 10 is held by a stage 61. An XYZ orthogonal coordinate system having a plane parallel to the outer surface of the silicon wafer 10 as an XY-plane and a normal direction of the outer surface of the silicon wafer 10 as a Z-direction is defined. The stage 61 receives control from a control device 40 and moves the silicon wafer 10 in an X-direction and a Y-direction. The control device 40 controls output timing, the pulse width, and power of a pulsed laser beam output from the laser diode 41. The pulse energy density of the first pulsed laser beam is calculated based on the pulse width, the power, and the beam size on the outer surface of a silicon wafer. The output timing of the first pulsed laser beam is set such that the oscillation duty ratio becomes 10% or lower and more preferably becomes 5% or lower. Furthermore, the control device 40 sends an oscillation trigger signal to the solid laser oscillator 51.

Various pieces of data, commands, and the like are input to the control device 40 through an input device 65. The control device 40 outputs a data processing result to an output device 66.

The control device 40 includes a storage device 64. The storage device 64 stores a relationship between the thickness of the silicon wafer 10 and the upper limit value for the pulse width satisfying a condition that the highest temperature on the non-irradiation surface becomes 400°C or lower (which will hereinafter be referred to as the first relationship). Moreover, the storage device 64 stores a relationship between the pulse width of an incident pulsed laser beam and the range of a depth at which protons implanted in a silicon wafer are activated (which will hereinafter be referred to as a second relationship).

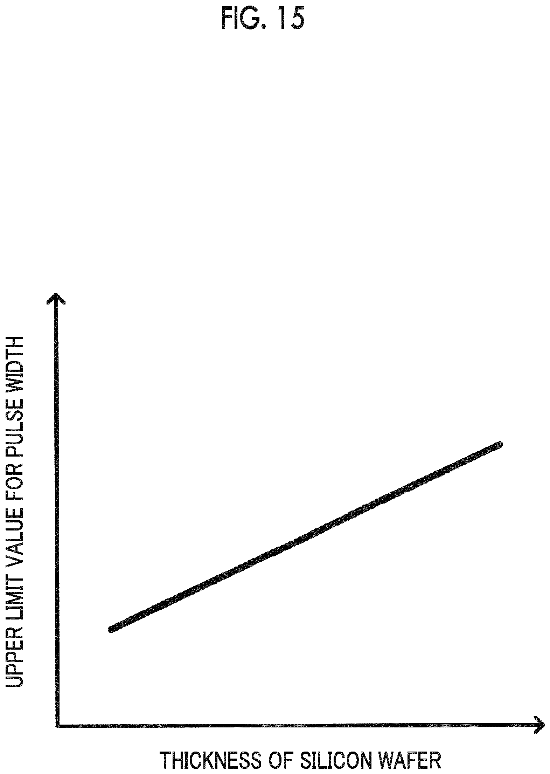

FIG. 15 illustrates an example of the first relationship. The horizontal axis expresses the thickness of the silicon wafer 10, and the vertical axis expresses the upper limit value for the pulse width. As seen from the results of the evaluation experiments illustrated in FIG. 6A and 6B, the upper limit value for the pulse width increases in accordance with the silicon wafer being thickened.

FIG. 16A illustrates an example of the second relationship. FIG. 16A corresponds to the graph of the simulation result in FIG. 9. The horizontal axis expresses the depth from the irradiation surface of the silicon wafer, and the vertical axis expresses the highest temperature. FIG. 16A illustrates the highest temperatures at the time of irradiation of pulsed laser beams having different pulse widths for each of the pulse widths. In FIG. 16A, for example, highest temperatures when the pulse width is PW1, PW2, PW3, and PW4 are illustrated. In a case of the same depth, the highest temperature increases when the pulse width becomes long. Protons can be activated in a region in which the highest temperature is between the upper limit value TH and the lower limit value TL.

FIG. 16B illustrates another example of the second relationship. In FIG. 16B, the horizontal axis expresses the pulse width, and the vertical axis expresses the depth. The dotted region in FIG. 16B indicates a depth at which protons can be activated. The graph in FIG. 16B can be made from the graph in FIG. 16A. For example, from the graph in FIG. 16A, it is ascertained that the depths at which the highest temperature at the time of the pulse width PW2 become the upper limit value TH and the lower limit value TL are D1 and D4, respectively. The depth at which protons can be activated when the pulse width is PW2 ranges from D1 to D4. In the graph in FIG. 16B, when the pulse width is PW2, positions at the depths of D1 and D4 respectively correspond to the shallowest position and the deepest position of the range in which protons can be activated. The graph in FIG. 16B can be made by obtaining the shallowest position and the deepest position of the range in which protons can be activated, with respect to a plurality of pulse widths.

Next, an annealing assisting function executed by the control device 40 (FIG. 10) will be described. When an operator operates the input device 65 and inputs the thickness of a silicon wafer, the control device 40 obtains the upper limit value for the pulse width based on the input thickness and the first relationship (FIG. 15) . The output device 66 displays the upper limit value for the pulse width. The thickness of a silicon wafer may be measured by an installed sensor, so that trouble of inputting the thickness is omitted.

When an operator operates the input device 65 and inputs the intended range of the depth for activation, the control device 40 obtains a recommendation range for the pulse width based on the input range of the depth and the second relationship (FIG. 16A or 16B) . In a case of using the second relationship illustrated in FIG. 16A, a pulse width, at which the highest temperature is settled between the upper limit value TH and the lower limit value TL at both the shallowest place and the deepest place of the input range of the depth, is extracted as a recommendation range. As necessary, the upper limit value and the lower limit value for a recommendation range for the pulse width can be calculated by performing interpolation computation. In a case of using the second relationship illustrated in FIG. 16B, the pulse width, at which the input range of the depth is included in the range in FIG. 16B in which activation can be achieved, is extracted as the recommendation range. The output device 66 displays the extracted recommendation range for the pulse width.

With reference to the upper limit value for the pulse width obtained from FIG. 15 and the recommendation range for the pulse width obtained from FIG. 16A or 16B, an operator can determine the pulse width at the time of actual annealing.

As an example, in a case where the input range of the depth is from D1 to D3, the range from the pulse widths PW1 to PW2 is extracted as a recommendation range. In a case of the pulse widths PW3 and PW4, the highest temperature at the depth D1 exceeds the upper limit value TH. Therefore, protons at the depth D1 cannot be activated. In a case where the input depth is from D2 to D4, the range from the pulse widths PW2 to PW3 is extracted as a recommendation range. In a case where the pulse width is PW1, the highest temperature at the depth D4 does not reach the lower limit value TL, and in a case where the pulse width is PW4, the highest temperature at the depth D2 exceeds the upper limit value TH.

In a case where the input range of the depth is from D1 to D5, there is no pulse width at which the highest temperature is settled between the upper limit value TH and the lower limit value TL at both the shallowest place and the deepest place. In this case, the pulse width PW2 at which the highest temperature at the depth D1 becomes the upper limit value TH, and the pulse width PW3 at which the highest temperature at the depth D5 becomes the lower limit value TL are extracted.

The control device 40 causes the output device 66 to display PW2 and PW3 as recommendation pulse widths together with the range of the depth at which activation can be achieved. An operator can determine the most preferable pulse width based on the displayed information.

In FIG. 14, the first pulsed laser beam output from the laser diode 41 and the second pulsed laser beam output from the solid laser oscillator 51 are coaxially united. In this laser annealing device, both annealing using the first pulsed laser beam and annealing using the second pulsed laser beam can be executed. As another configuration, in place of the condensing lens 46 of the propagation optical system 47, condensing lenses different from each other may be respectively disposed for the first pulsed laser beam and the second pulsed laser beam to be output from the laser diode 41 and the solid laser oscillator 51, thereby having a non-coaxial configuration. Alternatively, a device for performing annealing with the first pulsed laser beam output from the laser diode 41, and a device for performing annealing with the second pulsed laser beam output from the solid laser oscillator 51 may be isolated from each other.

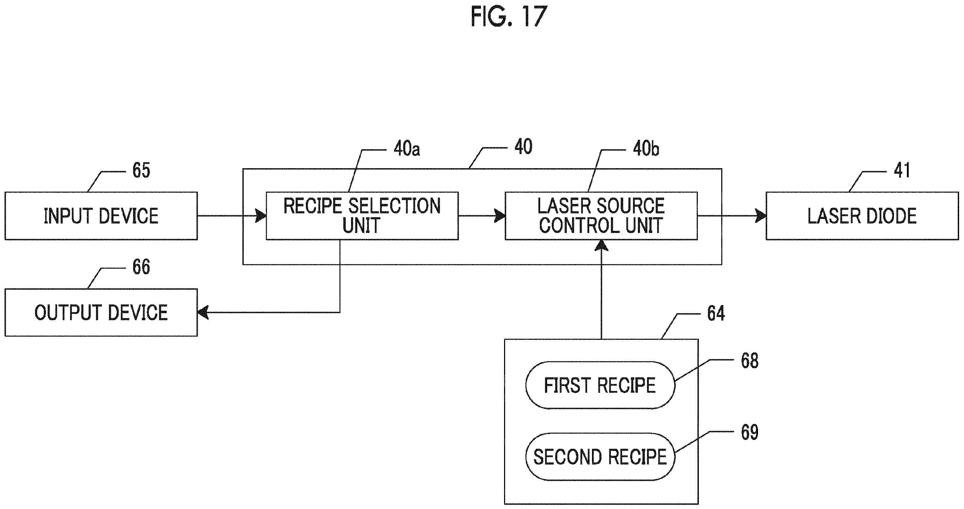

Next, with reference to FIG. 17, a laser annealing device according to an embodiment, not covered by the subject-matter of the claims, will be described. Hereinafter, description of configurations in common with the laser annealing device according to the embodiment illustrated in FIGs. 14 to 16B will be omitted.

In the present embodiment, the storage device 64 of the laser annealing device stores the recipe for regulating the output condition of the laser diode 41. The control device 40 controls the laser diode 41 based on this recipe. Various pieces of data, commands, and the like are input to the control device 40 through the input device 65. The control device 40 outputs a data processing result to the output device 66.

FIG. 17 is a block diagram of a function of the control device 40. The control device 40 includes a recipe selection unit 40a and a laser source control unit 40b. The storage device 64 stores a first recipe 68 and a second recipe 69. The first recipe 68 regulates a condition for outputting a pulsed laser beam to be applied when a wafer that is an annealing target is a wafer which has been subjected to furnace annealing, for example, the silicon wafer 20 illustrated in FIG. 5B. The second recipe 69 regulates a condition for outputting a pulsed laser beam to be applied when a wafer that is an annealing target is a wafer which has not been subjected to furnace annealing, for example, the silicon wafer 20 illustrated in FIG. 4A.

The recipe selection unit 40a causes the output device 66 to output information of urging an operator to select whether the wafer that is an annealing target is a wafer which has been subjected to furnace annealing or is a wafer which has not been subjected to furnace annealing (which will hereinafter be referred to as a wafer type) . The operator inputs information indicating the wafer type to the input device 65. The wafer type input to the input device 65 is given to the recipe selection unit 40a.

The laser source control unit 40b selects a recipe to be applied from the first recipe 68 and the second recipe 69 based on the wafer type given to the recipe selection unit 40a. Moreover, the laser source control unit 40b controls the laser diode 41 based on the selected recipe.

Next, excellent effects of the laser annealing device according to the present embodiment will be described.

In accordance with the wafer type of the silicon wafer 10 that is an annealing target, a pulsed laser beam can be output on condition preferable for annealing. Therefore, annealing for activating protons can be performed on preferable condition with respect to both cases of the silicon wafer 10 which has been subjected to furnace annealing and has not been subjected to furnace annealing. Moreover, annealing for eliminating a disorder can be performed for the silicon wafer 10 which has not been subjected to furnace annealing on preferable condition. In addition, since an operator is urged to select the wafer type, operability of the operator is improved.

Next, a modification example of the present embodiment will be described. In the present embodiment, an operator is deputed to select the wafer type. However, the wafer type of the silicon wafer 10 to be processed may be registered in the control device 40 in advance. Alternatively, a mark indicating the wafer type may be displayed in a wafer carrier or the like accommodating a silicon wafer that is an annealing target. When a sensor detects this mark, the control device 40 can acquire the wafer type of the silicon wafer 10 that is an annealing target.

### [Case where protons have been activated in advance]

Next, an example, in which protons have already been activated before performing laser annealing for recovering a disorder generated due to implantation of protons, will be described. This example is covered by the subject-matter of the claims only when executed with a pulse width of 70 µs to 100 µs.

Under the condition that the thickness of a silicon wafer in which protons are implanted is approximately 100 µm and the highest temperature on the non-irradiation surface is suppressed to 400°C or lower, as described with reference to FIGs . 9 and 10, activation of protons through laser annealing is limited to the depth of approximately 20 µm. Therefore, in a case where it is intended that protons are implanted in a region deeper than 20 µm and are activated, it is necessary to apply an annealing method other than laser annealing, for example, furnace annealing.

In this manner, in a case where protons near a peak concentration are activated by a method other than laser annealing, only recovering of a donor concentration in a disorder region may be performed through laser annealing.

A donor of protons is caused by a complex defect. As described with reference to FIG. 9, when the temperature due to laser annealing reaches 1, 160°C, a complex defect is recovered. As a result, a donor is eliminated. On the other hand, at a temperature at which protons can be activated by using furnace annealing, in other words, at a temperature at which a complex defect can be formed, a disorder cannot be recovered.

In consideration of the study described, defects differ in type between a complex defect and a disorder. However, in a case of using laser annealing, it is assumed that a disorder cannot be recovered at a temperature at which at least a complex defect remains. It is assumed that a temperature condition of at least 1,160°C or higher is required to recover a disorder through laser annealing. In a case where protons are activated in advance, a disorder may be recovered by controlling the pulse energy density and the heating time in laser annealing such that this temperature condition is satisfied.

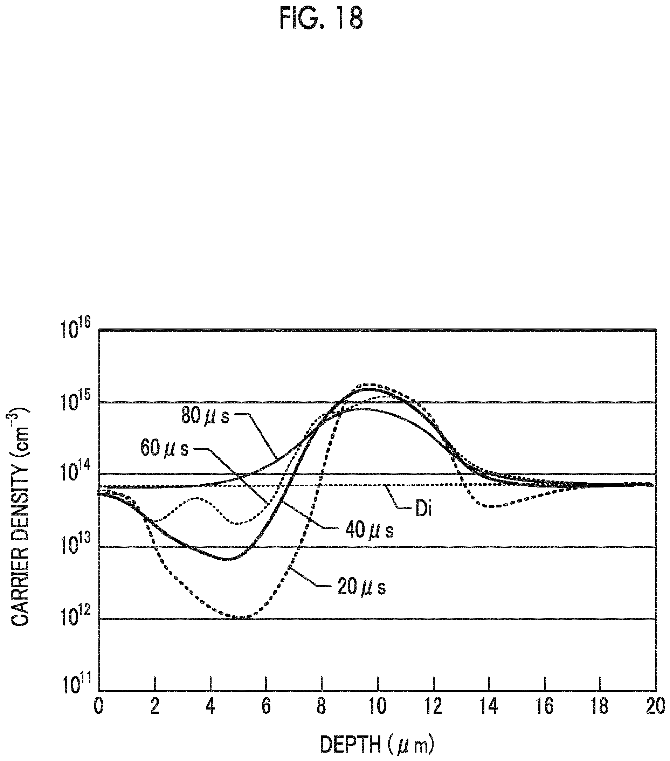

Next, with reference to FIG. 18, a result of another evaluation experiment in which protons are activated by using a pulsed laser beam will be described.

FIG. 18 is a graph illustrating a measurement result of the carrier density when protons are activated in the present evaluation experiment. The horizontal axis expresses the depth from the outer surface of a silicon wafer in the unit of "µm", and the vertical axis expresses the carrier density in the unit of "cm⁻³". The wavelength of a pulsed laser beam used in laser annealing is 808 nm. Protons are implanted on condition that the projection range Rp is 10 µm in the silicon wafer that is an annealing target. In this case, the tail depth of a distribution of protons is approximately 20 µm.

Next, an irradiation condition of a pulsed laser beam will be described. The pulse width is set to 20 µs, 40 µs, 60 µs, and 80 µs. The power density is set to a condition that the highest temperature on the outer surface of a silicon wafer becomes substantially the melting point (1,414°C) of silicon. The duty ratio is set to 2%. The beam shape on the outer surface of a silicon wafer is set to a long shape having a length of 2.8 mm and a width of 0.26 mm. This pulsed laser beam is caused to be incident into a predetermined region on the outer surface of a wafer, for example, substantially the entire region by repeating main scanning of the laser beam in a width direction of the beam shape and sub-scanning thereof in a length direction. The overlapping rate in the width direction (main scanning direction) is set to 67%, and the overlapping rate in the length direction (sub-scanning direction) is set to 50%. When scanning of a pulsed laser beam is performed at this overlapping rate, a laser pulse is incident into one place on the outer surface of a silicon wafer six times.

In FIG. 18, the thin solid line, the thin dotted line, the thick solid line, and the thick dotted line respectively indicate the carrier densities when annealing is performed on condition of the pulse widths of 80 µs, 60 µs, 40 µs, and 20 µs. The initial donor concentration Di of a silicon wafer is indicated with the dotted line.

Even on condition that the pulse width is 20 µs, the carrier concentration exceeds the initial donor concentration Di in a range of the depth of approximately 8 µm to 13 µm. In this manner, even if laser annealing is performed on condition of the pulse width of 20 µs, protons can be activated. Incidentally, in a region shallower than the depth of 8 µm, the carrier concentration is extremely lower than the initial donor concentration Di. It denotes that a disorder generated by protons which have passed through during ion-implantation has not been able to be recovered.

From the evaluation experiment illustrated in FIG. 18, the fact that the pulse width is preferably set to 80 µs or larger in order to recover a disorder generated when protons are implanted is derived.

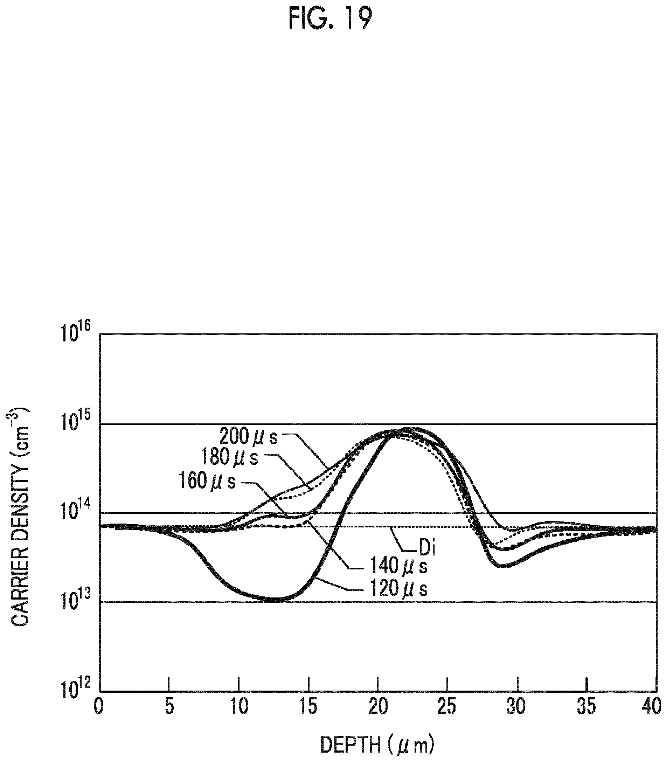

Next, with reference to FIG. 19, a result of still another evaluation experiment will be described. In the evaluation experiment illustrated in FIG. 18, a silicon wafer having the projection range Rp of 10 µm during implantation of protons is used. However, in the evaluation experiment illustrated in FIG. 19, a silicon wafer having the projection range Rp of 20 µm during implantation of protons is used.

FIG. 19 is a graph illustrating a measurement result of the carrier density when protons are activated in the present evaluation experiment. The horizontal axis expresses the depth from the outer surface of a silicon wafer in the unit of "µm", and the vertical axis expresses the carrier density in the unit of "cm⁻³". The wavelength of a pulsed laser beam used in laser annealing is 808 nm.

Next, an irradiation condition for a pulse laser will be described. The pulse width is set to 120 µs, 140 µs, 160 µs, 180 µs, and 200 µs. The power density is set to a condition that the highest temperature on the outer surface of a silicon wafer becomes substantially the melting point (1,414°C) of silicon. The duty ratio, the beam shape, the directions of main scanning and sub-scanning, and the overlapping rate are the same as the condition of the evaluation experiment illustrated in FIG. 18.

In FIG. 19, the thinnest solid line, the thinnest dotted line, the second thinnest solid line, the second thinnest dotted line, and the thickest solid line respectively indicate the carrier densities when annealing is performed on condition of the pulse widths of 200 µs, 180 µs, 160 µs, 140 µs, and 120 µs. The initial donor concentration Di of a silicon wafer is indicated with the dotted line.

A valley having a carrier density is formed near the depth of 27 µm due to a remaining EOR defect. The depth and the shape of this valley vary depending on the pulse width of a pulsed laser beam for irradiation. At the depth of approximately 40 µm, the carrier density is converged on the initial donor concentration Di. Based on this fact, it is ascertained that the tail depth of protons subjected to ion-implantation is approximately 40 µm.

It is ascertained that protons are activated in a region of the depth of 20 µm to 25 µm and near thereof on condition of the pulse width of 120 µs or larger. It is ascertained that a disorder in a region shallower than 17 µm is not recovered on condition that the pulse width is 120 µs. It is ascertained that in a case where the projection range Rp is set to 20 µm (tail depth of 40 µm), a disorder is substantially recovered on condition of the pulse width of 140 µs or larger. Even in a case where the tail depth is 40 µm or smaller, a disorder can be recovered by performing laser annealing on condition that the pulse width is 140 µs or larger, the case is not covered by the subject-matter of the claims.

When the pulse width is set to 200 µs, not covered by the subject-matter of the claims, an EOR defect formed near the depth of 30 µm is also recovered. In a case where the tail depth is 40 µm or smaller, if laser annealing is performed on condition of the pulse width of 200 µs or larger, an EOR defect can be recovered.

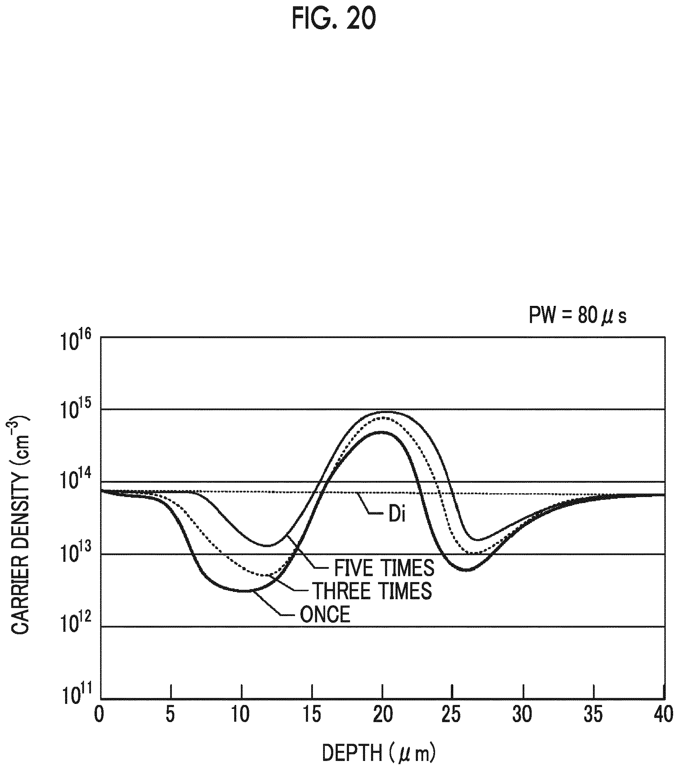

Next, with reference to FIG. 20, a result of further another evaluation experiment will be described. In the evaluation experiments illustrated in FIGs. 18 and 19, scanning of a pulsed laser beam is executed once in a predetermined region on the outer surface of a silicon wafer. In the evaluation experiment illustrated in FIG. 20, the pulse width is set to 80 µs, and the number of times of scanning is varied. Here, "scanning" denotes processing in which main scanning and sub-scanning are repeated at a predetermined overlapping rate and a pulsed laser beam is caused to be incident into a predetermined region on the outer surface of a silicon wafer.

FIG. 20 is a graph illustrating a measurement result of the carrier density when protons are activated in the present evaluation experiment. The horizontal axis expresses the depth from the outer surface of a silicon wafer in the unit of "µm", and the vertical axis expresses the carrier density in the unit of "cm⁻³". The annealing condition other than the pulse width and the number of times of scanning is the same as the annealing condition of the evaluation experiments illustrated in FIGs. 18 and 19. The power density is set to 144 kW/cm² in order to satisfy the condition that the highest temperature on the outer surface of a silicon wafer becomes near the melting point of silicon.

In FIG. 20, the thick solid line, the dotted line, and the thin solid line respectively indicate the carrier densities when the number of times of scanning is set to once, three times, and five times. It is ascertained that when the number of times of scanning is increased, the carrier density increases in a region shallower than the depth of approximately 15 µm. It denotes that more disorders are recovered by increasing the number of times of scanning. In addition, it is ascertained that when the number of times of scanning is increased, the carrier density increases even near the depth of approximately 25 µm. It denotes that more EOR defects are recovered by increasing the number of times of scanning.

In a case of performing laser annealing on condition of the pulse width of 80 µs and scanning of once, a disorder and an EOR defect cannot be sufficiently recovered. As illustrated in FIG. 19, when the pulse width is set to 140 µs or larger, the case is not covered by the subject-matter of the claims, a disorder is recovered, and when the pulse width is set to 200 µs or larger, an EOR defect is recovered. From the fact that these defects are recovered by widening the pulse width, it is assumed that a disorder and an EOR defect are not sufficiently recovered on condition of the pulse width of 80 µs because the heating time is short.

When the cumulative heating time is lengthened by increasing the number of times of scanning, so that more disorders and EOR defects can be recovered. As illustrated in FIG. 20, it is ascertained that in a case of five times of scanning, recovery of a disorder and an EOR defect is insufficient. If scanning is performed more than five times, more disorders and EOR defects can be recovered. The required number of times of scanning for sufficiently recovering a disorder and an EOR defect can be found through an experiment. For example, the required number of times of scanning for sufficiently recovering the carrier density in a region in which a disorder and an EOR defect have been generated to the initial donor concentration Di can be found through an experiment.

As seen from the result of the evaluation experiment illustrated in FIG. 19, if the pulse width is widened, a disorder and an EOR defect can be sufficiently recovered. However, when the pulse width is widened, the range of a rise in temperature on the outer surface (non-irradiation surface) on a side opposite to the laser irradiation surface of a silicon wafer. Therefore, in a case where an element structure including a metal or the like having a low melting point is formed on the non-irradiation surface as illustrated in FIG. 1B, the upper limit value for the pulse width is limited based on the allowable highest temperature on the non-irradiation surface. In this case, the pulse width is reduced to be shorter than the upper limit value and the number of times of scanning is increased, so that a rise in temperature on the non-irradiation surface can be suppressed, and a disorder and an EOR defect can be sufficiently recovered.

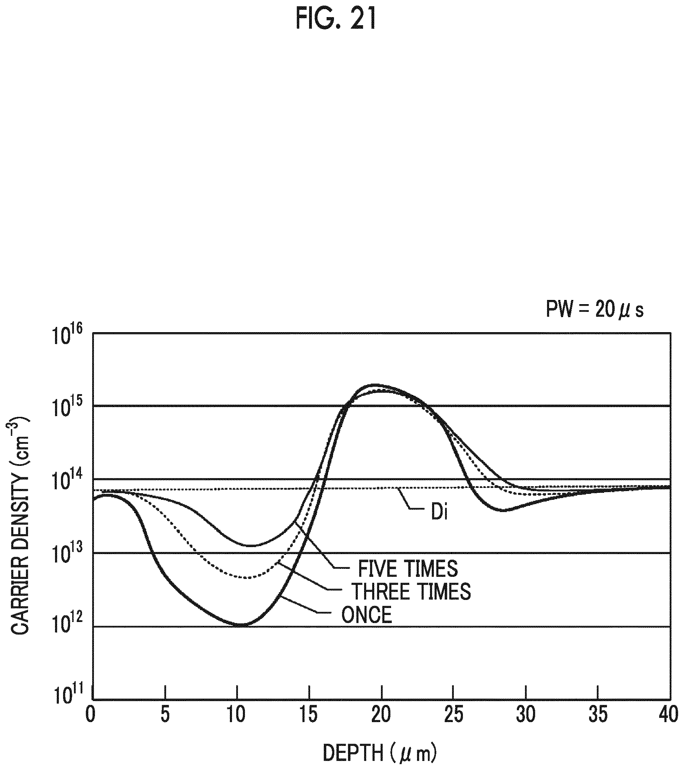

Next, with reference to FIG. 21, a result of yet another evaluation experiment will be described. In the evaluation experiment illustrated in FIG. 20, the pulse width is set to 80 µs. In the evaluation experiment illustrated in FIG. 21, the pulse width is set to 20 µs. Other annealing conditions are the same as the annealing condition of the evaluation experiment illustrated in FIG. 20. The power density is set to 380 kW/cm² in order to satisfy the condition that the highest temperature on the outer surface of a silicon wafer becomes near the melting point of silicon.

FIG. 21 is a graph illustrating a measurement result of the carrier density when protons are activated in the present evaluation experiment. The horizontal axis expresses the depth from the outer surface of a silicon wafer in the unit of "µm", and the vertical axis expresses the carrier density in the unit of "cm⁻³".

In FIG. 20, the thick solid line, the dotted line, and the thin solid line respectively indicate the carrier densities when the number of times of scanning is set to once, three times, and five times. As seen from the result of the evaluation experiment illustrated in FIG. 20, even on condition that the pulse width is 20 µs, more disorders and EOR defects can be recovered by increasing the number of times of scanning.

For example, if the implantation depth (tail depth) of protons is approximately 20 µm, a disorder and an EOR defect can be sufficiently recovered with a short pulse width of approximately 80 µs, as illustrated in FIG. 18. Incidentally, when the implantation depth of protons exceeds 20 µm and becomes approximately 40 µm, the pulse width has to be further lengthened in order to sufficiently recover a disorder and an EOR defect, as illustrated in FIG. 19. A method, in which the number of times of scanning during laser annealing illustrated in FIGs. 20 and 21 is set to a plurality of times, exhibits particularly excellent effects in a case where the implantation depth of protons exceeds 20 µm and becomes approximately 40 µm. Moreover, the method, in which the number of times of scanning during laser annealing is set to a plurality of times, exhibits particularly excellent effects in a case where an element structure is formed on a non-irradiation surface.

### Reference Signs List

10 n-type silicon wafer
10A non-irradiation surface
10B laser irradiation surface
11 p-type base region
12 n-type emitter region
13 gate electrode
14 gate insulating film
15 emitter electrode
16 n-type buffer layer
16a second layer in which phosphorus is implanted
16b third layer in which protons are implanted
17 p-type collector layer
17a first layer in which boron is implanted
18 collector electrode
20 silicon wafer
21 outer surface of silicon wafer
22 proton-implanted region
22a n-type layer realized by activating protons
23 disorder
30 silicon wafer
31 proton-implanted layer
31a n-type layer realized by activating protons
32 disorder
40 control device
40a recipe selection unit
40b laser source control unit
41 laser diode
42 attenuator
43 beam expander
44 homogenizer
45 dichroic mirror
46 condensing lens
47 propagation optical system
51 solid laser oscillator
52 attenuator
53 beam expander
54 homogenizer
55 bending mirror
61 stage
64 storage device
65 input device
66 output device
68 first recipe
69 second recipe

## Claims

1. A laser annealing method comprising:
a step of preparing a silicon wafer (10, 20, 30) in which an element forming a complex defect that serves as a donor by being activated is implanted in an outer layer portion on one outer surface; and
a step of activating the element by causing a pulsed laser beam having a wavelength within a range of 690 nm to 950 nm to be incident onto a laser irradiation surface that is the outer surface of the silicon wafer (10, 20, 30) in which the element is implanted,
wherein in the step of activating the element, the pulsed laser beam is caused to be incident onto the silicon wafer (10, 20, 30) with a pulse width of 70 µs to 100 µs and a pulse energy density of the pulsed laser beam on condition that at least the element in a part of a region to a depth of 20 µm from the outer surface is activated without melting the laser irradiation surface (10B), and wherein
a highest temperature on a laser irradiation surface (10B) of the silicon wafer (10, 20, 30) becomes substantially 1414°C or is within a range of 1000°C to lower than 1414°C.

2. The laser annealing method according to Claim 1,
wherein a highest temperature on a non-irradiation surface on a side opposite to the laser irradiation surface (10B) of the silicon wafer (10, 20, 30) does not exceed 400°C.

3. The laser annealing method according to any one of Claims 1 or 2,
wherein a beam cross-section of the pulsed laser beam on the laser irradiation surface (10B) has a shape elongated in one direction, and a width of the beam cross-section is 200 µm or larger.

4. The laser annealing method according to any one of Claims 1 to 3,
wherein a duty ratio of oscillation of the pulsed laser beam is 5% or lower.

5. The laser annealing method according to any one of Claims 1 to 4,
wherein the donor is added to an entire region of the silicon wafer (10, 20, 30) in a thickness direction such that an initial donor concentration is established, and
wherein in the step of activating the element, the pulse width and the pulse energy density of the pulsed laser beam are set on condition that at least one of a disorder generated in a passing region that is a region through which the element has passed when the element is implanted and an end-of-range defect generated in an end-of-range region is eliminated so that a carrier density of the region is recovered to at least the initial donor concentration of the silicon wafer (10, 20, 30) before the element is implanted, and the pulsed laser beam is caused to be incident onto the silicon wafer (10, 20, 30).

## Patentansprüche

1. Lasertemperverfahren, umfassend:
einen Schritt des Vorbereitens eines Siliziumwafers (10, 20, 30), in dem ein Element, das einen komplexen Defekt bildet, der durch Aktivieren als ein Donator dient, in einen äußeren Schichtabschnitt auf einer Außenfläche implantiert wird; und
einen Schritt des Aktivierens des Elements, indem ein gepulster Laserstrahl mit einer Wellenlänge in einem Bereich von 690 nm bis 950 nm veranlasst wird, auf eine Laserbestrahlungsfläche, die die Außenfläche des Siliziumwafers (10, 20, 30) ist, aufzutreffen, in den das Element implantiert ist,
wobei in dem Schritt des Aktivierens des Elements der gepulste Laserstrahl veranlasst wird, auf den Siliziumwafer (10, 20, 30) mit einer Pulsbreite von 70 µs bis 100 µs und einer Pulsenergiedichte des gepulsten Laserstrahls unter der Bedingung aufzutreffen, dass zumindest das Element in einem Teil eines Bereichs bis zu einer Tiefe von 20 µm von der Außenfläche aktiviert wird, ohne die Laserbestrahlungsoberfläche (10B) zu schmelzen, und wobei eine höchste Temperatur auf einer Laserbestrahlungsoberfläche (10B) des Siliziumwafers (10, 20, 30) im Wesentlichen 1414°C erreicht oder in einem Bereich von 1000°C bis weniger als 1414°C liegt.

2. Lasertemperverfahren nach Anspruch 1,
bei dem eine höchste Temperatur auf einer Nicht-Bestrahlungsoberfläche auf einer der Laserbestrahlungsoberfläche (10B) gegenüberliegenden Seite des Siliziumwafers (10, 20, 30) 400°C nicht überschreitet.

3. Lasertemperverfahren nach einem der Ansprüche 1 oder 2,
bei dem ein Strahlquerschnitt des gepulsten Laserstrahls auf der Laserbestrahlungsfläche (10B) eine in eine Richtung langgestreckte Form aufweist und eine Breite des Strahlquerschnitts 200 µm oder größer ist.

4. Lasertemperverfahren nach einem der Ansprüche 1 bis 3,
bei dem ein Tastverhältnis von Oszillation des gepulsten Laserstrahls 5 % oder weniger beträgt.

5. Lasertemperverfahren nach einem der Ansprüche 1 bis 4,
bei dem der Donator einem gesamten Bereich des Siliziumwafers (10, 20, 30) in einer Dickenrichtung derart hinzugefügt wird, dass eine anfängliche Donatorkonzentration gebildet wird, und
bei dem in dem Schritt des Aktivierens des Elements die Pulsbreite und die Pulsenergiedichte des gepulsten Laserstrahls unter der Bedingung eingestellt werden, dass wenigstens eines von einer Störung, die in einem Durchgangsbereich erzeugt wird, der ein Bereich ist, durch den das Element hindurchgegangen ist, wenn das Element implantiert wird, und einem Endbereichsdefekt, der in einem Endbereichsbereich erzeugt wird, beseitigt wird, so dass eine Ladungsträgerdichte des Bereichs auf wenigstens die anfängliche Donatorkonzentration des Siliziumwafers (10, 20, 30) wiederhergestellt wird, bevor das Element implantiert wird, und der gepulste Laserstrahl wird dazu veranlasst, auf den Siliziumwafer (10, 20, 30) aufzutreffen.

## Revendications

1. Une méthode de recuit laser comprenant :
une étape de préparation d'une tranche de silicium (10, 20, 30) lors de laquelle un élément qui forme un défaut complexe qui sert de donneur en étant activé est implanté dans une partie de couche externe sur une surface externe ; et
une étape d'activation de l'élément en provoquant l'incidence d'un faisceau laser pulsé ayant une longueur d'onde comprise entre 690 nm et 950 nm sur une surface d'irradiation laser qui est la surface externe de la tranche de silicium (10, 20, 30) dans laquelle l'élément est implanté,
dans laquelle, à l'étape d'activation de l'élément, le faisceau laser pulsé est incident sur la tranche de silicium (10, 20, 30) avec une durée d'impulsion de 70 µs à 100 µs et une densité d'énergie d'impulsion du faisceau laser pulsé à condition qu'au moins l'élément dans une partie d'une zone à une profondeur de 20 µm de la surface externe soit activé sans faire fondre la surface d'irradiation laser (10B), et
dans laquelle
une température la plus élevée sur une surface d'irradiation laser (10B) de la tranche de silicium (10, 20, 30) devient sensiblement de 1414°C ou est comprise entre 1000°C et moins de 1414°C.

2. La méthode de recuit laser selon la revendication 1,
dans laquelle une température la plus élevée sur une surface de non-irradiation sur un côté opposé à la surface d'irradiation laser (10B) de la tranche de silicium (10, 20, 30) ne dépasse pas 400°C.

3. La méthode de recuit laser selon l'une quelconque des revendications 1 ou 2,
dans laquelle une section transversale de faisceau du faisceau laser pulsé sur la surface d'irradiation laser (10B) présente une forme allongée dans une direction, et une largeur de la section transversale de faisceau est de 200 µm ou plus.

4. La méthode de recuit laser selon l'une quelconque des revendications 1 à 3,
dans laquelle un régime d'oscillation du faisceau laser pulsé est de 5% ou moins.

5. La méthode de recuit laser selon l'une quelconque des revendications 1 à 4,
dans laquelle le donneur est ajouté à une zone entière de la tranche de silicium (10, 20, 30) dans une direction d'épaisseur de sorte qu'une concentration en donneur initiale soit établie, et
dans laquelle, à l'étape d'activation de l'élément, la durée d'impulsion et la densité d'énergie d'impulsion du faisceau laser pulsé sont définies à condition qu'au moins l'un d'un problème généré dans une zone de passage qui est une zone à travers laquelle l'élément est passé lorsque l'élément a été implanté et d'un défaut de fin de plage généré dans une zone de fin de plage soit éliminé de sorte qu'une densité de porteur de la zone soit rétablie au moins à la concentration en donneur initiale de la tranche de silicium (10, 20, 30) avant que l'élément soit implanté, et le faisceau laser pulsé est incident sur la tranche en silicium (10, 20, 30).
